(19) Europäisches Patentamt

European Patent Office

Office européen des brevets

(11) **EP 1 363 320 A1**

(12) **EUROPEAN PATENT APPLICATION**
published in accordance with Art. 158(3) EPC

(43) Date of publication:
**19.11.2003 Bulletin 2003/47**

(51) Int Cl.7: **H01L 21/316**, H01L 21/31

(21) Application number: **02715794.0**

(22) Date of filing: **18.01.2002**

(86) International application number:
**PCT/JP02/00302**

(87) International publication number:
**WO 02/058129 (25.07.2002 Gazette 2002/30)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **18.01.2001 JP 2001010827**
**19.01.2001 JP 2001011070**
**19.01.2001 JP 2001049436**
**18.11.2001 JP 2001392833**

(71) Applicants:
• **KABUSHIKI KAISHA WATANABE SHOKO**
**Chuo-ku, Tokyo 103-0022 (JP)**
• **Toda, Masayuki**
**Yonezawa-shi, Yamagata 992-0026 (JP)**

(72) Inventors:
• **YAMOTO, Hisayoshi,**
**WACOM ELECTRIC CO., LTD**
**Tokyo 103-0022 (JP)**

• **TODA, Masayuki**
**Yonezawa-shi, Yamagata 992-0026 (JP)**
• **FUKAGAWA, Mitsuru,**
**WACOM ELECTRIC CO, LTD**
**Tokyo 103-0022 (JP)**
• **UMEDA, Masaru,**
**KABUSHIKI KAISHA WATANABE SHOKO**
**Tokyo 103-0022 (JP)**
• **FUKAGAWA, Mitsuru,**
**c/o WACOM ELECTRIC CO., LTD**
**Tokyo 103-0022 (JP)**

(74) Representative:
**Sawodny, Michael-Wolfgang, Dr. Dipl.-Phys.**
**Dr. Weitzel & Partner,**
**Friedenstrasse 10**
**89522 Heidenheim (DE)**

(54) **FERROELECTRIC THIN FILM, METAL THIN FILM OR OXIDE THIN FILM, AND METHOD AND APPARATUS FOR PREPARATION THEREOF, AND ELECTRIC OR ELECTRONIC DEVICE USING SAID THIN FILM**

(57)     The object of the present invention is to provide a ferroelectric thin film that has the best range of the composition where an excellent remanent polarization characteristic is obtained and, at the same time, has a bismuth type layered crystal structure with high reliability.

The ferroelectric thin film of the present invention is a ferroelectric thin film of layered crystal structure comprising at least-tantalum and oxygen (O) among carbon, Strontium (Sr), bismuth (Bi), tantalum (Ta), and niobium (Nb), characterized by assuming the composition formula to be $SrBi_y Ta_2 O_{9\pm d}$ or $Sr_x Bi_y (Ta,Nb)_2 O_{9\pm d}$ (provided that, $0.90 \leqq x < 1.00$, $1.70 < y \leqq 3.20$, and $0 \leqq d \leqq 1.00$) and the carbon content be 5at% or less.

Fig. 1

EP 1 363 320 A1

**Description**

Technical field

The prevent invention concerns a thin film such as a ferroelectric thin film, a metallic thin film or an oxide thin film and an electronic/electric device using the thin film, and more particularly, a ferroelectric thin film of bismuth type layered crystal structure and a manufacturing method thereof, especially a ferroelectric thin film preferably used for ferroelectric devices such as a capacitor, a nonvolatile memory, etc. and a manufacturing method, a manufacturing device and ferroelectric devices thereof.

Here, as a ferroelectric device, for instance, a semiconductor integrated circuit, a semiconductor element, a TFT drive display device, a liquid crystal display, an organic EL display, a field emission display terminal, a plasma display terminal, etc. including a ferroelectric thin film, a metallic thin film or an oxide electroconductive thin film can be cited.

Background art

Recently, the applied research into the nonvolatile memory cell that uses the ferroelectric thin film is actively advanced as the deposition technology advances. This nonvolatile memory cell is a nonvolatile random access memory (Ferroelectric Random Access Memories; FeRAM) cell enabling a high speed rewriting by the use of a high-speed polarization reversing of the ferroelectric thin film and the remanent polarization. A bismuth type layered crystal structural oxide can be enumerated as a material consisting such a memory. This bismuth type layered crystal structural oxide attracts attention because the fatigue phenomenon, namely decrease in the remanent polarization due to the reiterated rewriting, that was the maximum disadvantage of a PZT (compound whose structural formula is $PbZr_{1-x}Ti_xO_3$) type material that has been used so far, is not observed.

The development of the technology of making the thin film is indispensable to apply such a ferroelectric material to an electronic device, and in addition, the bulk property of a ferroelectric is requested to be achieved in the thin film form.

Therefore, it is necessary to use a thin film deposition that can achieve various characteristics such as, stoichiometric mixture ratio, crystalline, crystal structure, crystal orientation etc. desired in the thin film form. The ferroelectric thin film that uses these materials are obtained actually by the method of spin coat such as the MOD (Metal Organic Decomposition) method or the sol-gel process, etc., and shows an excellent, ferroelectric characteristic. The spin coat method is high in throughput, excellent in the composition control, and there is also an advantage with a cheap cost of the manufacturing device.

However, there is also a problem of low matching property with the current silicon device process (for example; FeRAM-LSI), because this method of manufacturing thin film is mediocre in step coverage (there is an action that smoothes the surface difference), the pinhole density of the thin film is high, and the withstand voltage is low and susceptible to deterioration.

Then, the development of a chemical vapor phase growth method, that is, a CVD (Chemical Vapor Deposition) method, strongly desired for applying these materials to highly integrated memories, which is excellent in the step coverage with the miniaturization, film quality, uniformity, particle prevention and processing speed, etc..

Actually, reports are few concerning the making method of the ferroelectric thin film of the bismuth type layered crystal structure using the CVD method, and there are following theses and unexamined publications concerning the formation with the CVD method of the $SrBi_2Ta_2O_9$ thin film that is one of ferroelectrics of the bismuth type layered crystal structure.

1. "Performance of $SrBi_2Ta_2O_9$ Thin Films Grown by Chemical Vapor Deposition for Nonvolatile Memory Applications".
   C.Isobe, H.Yamoto, H.Yagi et al
   9th International Symposium on Integrated Ferroelectrics.Mar.1997
2. Japanese Patent Laid-Open 1996-325019, Japanese Patent Laid-Open 1997-142844,
3. Japanese Patent Laid-Open 1999-43328, 35394
4. S. B.Desu

However, in the study of S.B.Desu and others, the remanent polarization value is $2Pr=8.3\mu C/cm^2$, which is an index of the polarization state of the ferroelectric thin film, is far small compared with the value ($2Pr=15\sim25\mu C/cm^2$) usually obtained in a thin film made by the spin coat method. Moreover, the deposition speed is 3nm/min, which is far from the practical level (10 to 20nm/min). Moreover, for the Japanese Patent Laid-Open 1996-325019, the remanent polarization value is $2Pr=10-11\mu C/cm^2$, and is smaller than the value usually obtained in the thin film by the spin coat method, though the deposition speed is 15 to 20nm/min, that is a value that can be endured at the practical level. In addition, a high temperature heat-treatment of 800°C×60min is needed in the oxygen atmosphere to obtain the polarization characteristic after depositing by the CVD method, and the platinum thin film that it is expensive and unsuitable for a microfabrication is adopted as an electrode material that can endure this heat-treatment. If the adoption of a platinum electrode is indispensable, it is almost impossible to realize the FeRAM-LSI (Example; 0.13μm rule 256Mb FeRAM-LSI) for which the microfabrication is essential.

Thus, the main factor incapable obtaining an enough remanent polarization characteristic in the ferroelectric thin film of the bismuth type layered crystal structure made by the CVD method is not known the best composition of the thin film capable of giving the remanent polarization characteristic satisfactorily. That is, the range of the film composition that gives an excellent remanent polarization characteristic is limited in the oxide that consists of strontium (Sr), bismuth (Bi), tantalum (Ta), and oxygen (O) that is one of the bismuth type layered crystal structural ferroelectrics, for instance, and it is thought that the best composition thereof is a range of the compositions other than stoichiometric composition ($SrBi_2Ta_2O_9$). In addition, it is because a large amount (30 to 40at%) of impurity carbon is included.

The prior art shall be described again in detail.

In general, the $SrBi_2TaO_9$ ferroelectric thin film formation is made by the spin coat method.

While the possibility was proven, the promising MOCVD (metalorganic chemical vapor deposition) method thereof, it is not yet introduced into mass production, that was announced in 1996.

The raw material of the ferroelectric thin film includes, for instance, three kinds of organometallic complex Sr $(DPM)_2$, $Bi(C_6H_5)_3$, $Ta(OC_2H_5)_5$, melt respectively in THF (Tetorahidorofran), hexane, and other solvents, and used as a raw material solution.

Recently, $Sr(Ta(OEt)_6)_2$ and $Bi(OtAm)_3$ can be melted in hexane and other solvents, and used as a raw material solution.

Note that DPM is an abbreviation of bis(diphenylphosphino)methane.

Table 1 shows each material characteristic.

Table 1: Characteristics of typical raw material for ferroelectric thin film formation

|  | Boiling point (°C) /pressure(mmHg) | Melting point (°C) |
|---|---|---|
| Sr(DPM)2 | 231/0.1 | 210 |
| $Bi(C_6H_5)_3$ | 130/0.1 | 80 |
| $Ta(OC_2H_5)_5$ | 118/0.1 | 22 |
| THF | 67 | -109 |
| $Sr(Ta(OEt)_6)_2$ | 176/0.1 | 130 |
| $Bi(OtAm)_3$ | 87/0.1 | 87 |

The ferroelectric thin film cannot be formed by the conventional CVD method for forming a thin film by the gas phase reaction, because raw material of the ferroelectric thin film is a solid at the normal temperature, and the vapor pressure is also low, as shown in Table 1.

Therefore, a flash CVD method where the thin film is formed by the CVD method through an instantaneous vaporization of a solution dissolving the materials in a solvent, using a vaporizer, is proposed.

Here, an example of formation of the ferroelectric thin film is described, and it is similar to the case where forming a dielectric substance thin film, a metallic thin film, and an oxide electroconductive thin film by using a material which is solid at the normal temperature and has a low vapor pressure.

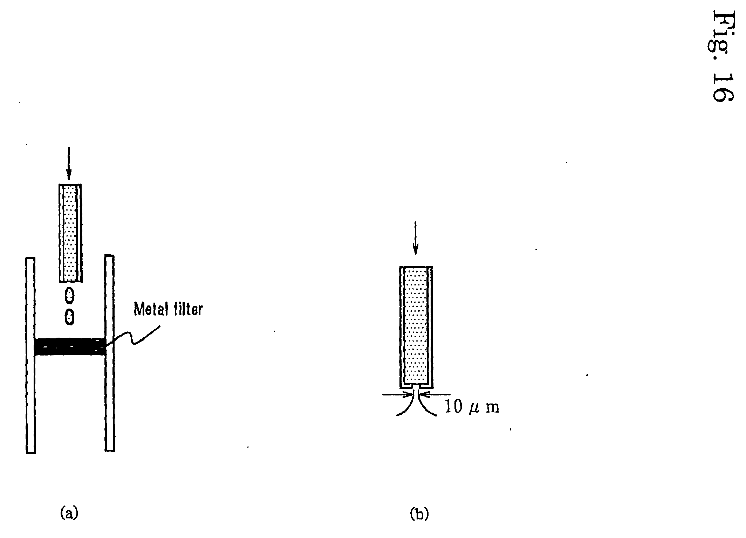

Respective methods shown in Fig. 16 are known, so far, as a technology concerning the vaporizer. The one shown in Fig. 16(a) is called a metal filter type and it is a method that introduces and vaporizes the raw material solution heated to a prescribed temperature into a metal filter used to increase the contact area between an atmospheric gas and the raw material solution of the $SrBi_2TaO_9$ ferroelectric thin film.

However, in this technology, the metal filter is clogged by the vaporization for several hours, so there is a problem that it cannot bear the long-term use. The present inventor guessed that it is because the solution is heated and vaporized from the one having a low vaporization temperature.

Fig. 16(b) shows a technology that the raw material solution is discharged from a small hole of 10μm by applying the pressure of 30kgf/cm$^2$ to it and vaporized by the expansion.

However, the problem of clogging the small hole by the use for several hours, and not enduring a long-term use is also observed in this technology.

Moreover, the problem that a steady raw material supply cannot be achieved to a reaction is caused, because the solvent with the highest vapor pressure (in the following case, THF) evaporates promptly and an organometallic complex deposits and adheres on the heating face, when the raw material solution is a mixture solution of organometallic complexes, for instance, $Sr(DPM)_2/THF$, $Bi(C_6H_5)_3/THF$ and $Ta(OC_2H_5)_5/THF$, and this mixture solution is evaporated by heating. As for all these methods shown in Fig. 16, the calorie which could vaporize or alter the solvent in the liquid or mist state turns up to be added.

In addition, in MOCVD, to obtain an excellent film uniformly, a vaporization gas in which the raw material solution is dispersed uniformly is required to be obtained. However, in the prior art, such request is not necessarily complied with.

The present inventor offers, separately, the next technology so that the request may be complied with.

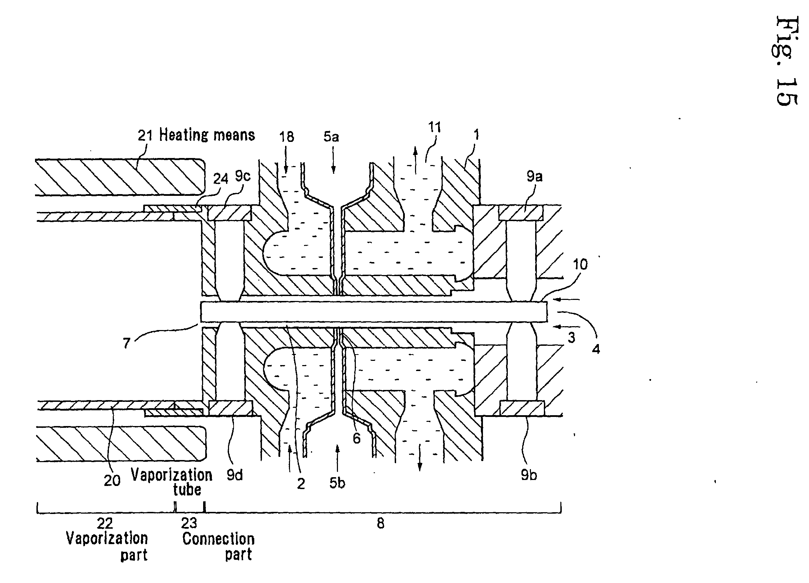

That is, as shown in Fig. 15, a vaporizer for MOCVD, comprises:

① a dispersion part including a gas passage formed internally, a gas inlet to introduce a pressurized career gas into the gas passage, a means to supply the raw material solution to the gas passage, a gas outlet to send the career gas including the raw material solution to the vaporization part, a means to cool the gas passage, and a radiant heat prevention jet part cooled so that thermal energy should not be applied to the raw material gas in the dispersion part by the radiant heat from the vaporization part; and

② a vaporization part for heating and vaporizing the career gas including the raw material solution, sent from the dispersion part, the vaporization part comprising a vaporization tube whose one end is connected to a reaction tube of the MOCVD device and the other end is connected to said gas outlet, and a heating means to heat the vaporization tube.

Thereby, the vaporizer is composed in such a manner that thermal energy should not be applied to the raw material gas in the dispersion part by the radiant heat from the vaporization part.

Since the vaporizer for MOCVD of this technology is little clogged, it enables to use a long term and to stably supply material to the reaction part compared with the prior art.

Moreover, as for this technology, an inlet of the oxygen heated beforehand has been installed downstream the vaporization part.

However, even by using this technology, the deposition of the crystal might still be observed in the gas passage to cause clogging.

Moreover, a large amount of carbon (30 to 40at%) is included in the formed film. It is necessary to anneal at the high temperature after film deposition (example: oxygen atmosphere of 800°C for 60 minutes) in order to remove this carbon.

In addition, when deposition is to be done, a large difference of composition ratio is caused.

The object of the present invention is to provide a ferroelectric thin film that has the best range of composition where an excellent remanent polarization characteristics can be obtained and, at the same time, has a bismuth type layered crystal structure with high reliability.

Another object of the present invention is to provide a manufacturing method and a manufacturing device of a ferroelectric thin film that can manufacture the ferroelectric thin film of the bismuth type layered crystal structure of the best composition, with satisfactory precision and reproducibility, even if a high temperature heat-treatment is executed.

Another object of the present invention is to provide a vaporizer that can be used for a long term without clogging or the like, and supply stably a raw material to a reaction part.

Another object of the present invention is to provide a vaporizer, a deposition device, other various devices, and a vaporization method that can extremely reduce the content of a carbon in the film even in the as-deposited state, and accurately control the composition ratio of the film.

Another object of the present invention is to provide a vaporizer and a vaporization method by which a vaporization gas with uniformly dispersed raw material solution can be obtained.

Disclosure of the Invention

The subject matter of the present invention consists respectively in the following.

A ferroelectric thin film of layered crystal structure comprising at least tantalum and oxygen (O) among carbon, Strontium (Sr), bismuth (Bi), tantalum (Ta), and niobium (Nb), of which a composition formula is $SrBi_yTa_2O_{9\pm d}$ or $Sr_xBi_y(Ta,Nb)_2O_{9\pm d}$ (provided that, $0.90 \leqq x < 1.00$, $1.70 < y \leqq 3.2$, and $0 \leqq d \leqq 1.00$) and the carbon content is 5at% or less.

A manufacturing method of ferroelectric thin film, comprising steps of:

dispersion for atomization of a solution that disperses or dissolves in a solvent an organometallic complex including respective elements of at least strontium (Sr), bismuth (Bi), and tantalum (Ta);
vaporization to vaporize it in a vaporization chamber;

gas mixture for mixing a career gas including a vaporized organometallic complex, and oxidizing gases such as an oxygen gas, an ozone gas, at a prescribed rate;

thin film formation for forming an oxide thin film by making the career gas including the mixed organometallic complex react with the oxidizing gas in a reaction chamber within a prescribed range of pressure for decomposition, and depositing it on a substrate heated within a prescribed range of temperature; and

heat treatment for forming a ferroelectric thin film of a desired bismuth layer structure by applying a heat-treatment of a prescribed range of temperature to the oxide thin film formed on the substrate and giving a crystallization process performing a composition control.

A ferroelectric device characterized by having the ferroelectric thin film.

A thin film formed by using a deposition device comprising a vaporizer provided with a radiation prevention part having a small hole outside the gas outlet having:

① a dispersion part including:

a gas passage formed internally,
a gas inlet to introduce a career gas into the gas passage,
a means to supply a raw material solution to the gas passage,
a gas outlet to send the career gas including the raw material solution to a vaporization part, and
a means to cool the gas passage, and

② a vaporization part for heating and vaporizing the career gas including the atomized raw material solution, sent from the dispersion part, the vaporization part comprising:

a vaporization tube whose one end is connected to a reaction part of various units such as deposition, and the other end is connected to the gas outlet, and
a heating means to heat the vaporization tube.

A thin film formed by using a deposition device comprising a vaporizer having:

① a dispersion part including:

a gas passage formed internally,
a gas inlet to introduce a pressurized career gas into the gas passage,
a means to supply the raw material solution to the gas passage, and
a gas outlet to send the career gas including the raw material solution to the vaporization part, and

② a vaporization part for heating and vaporizing the career gas including the raw material solution, sent from the dispersion part, the vaporization part comprising:

a vaporization tube whose one end is connected to a reaction part of various units such as a deposition, and the other end is connected to the gas outlet, and
a heating means to heat the vaporization tube; wherein

③ the dispersion part comprises

a dispersion main body having a cylindrical or conical hollow part and
a rod having an outer diameter smaller than the inner diameter of the cylindrical or conical hollow part, in which

the rod has one or more spiral groove(s) on the vaporizer side of the outer periphery thereof, and is inserted in the hollow part, and its inner diameter expands in a taper shape toward the vaporizer side, and
④ a radiation prevention part having a small hole on the gas outlet side and the inner diameter expanding towards the vaporizer side is installed outside the gas outlet.

The thin film of any one of claims 26- to 36, characterized in that the surface of the rod is a surface where electrolytic polishing or compound electrolysis grinding is exerted.

A thin film formed by using a deposition device having a vaporizer comprising;

① a dispersion part including:

a gas passage formed internally,
a gas inlet to introduce a career gas into the gas passage,
a means to supply a raw material solution to the gas passage,
a gas outlet to send the career gas including the raw material solution to a vaporization part, and
a means to cool the gas passage, and

② a vaporization part for heating and vaporizing the career gas including the raw material solution, sent from the dispersion part, the vaporization part including;

a vaporization tube whose one end is connected to a reaction part of various units such as a deposition, and the other end is connected to the gas outlet, and
a heating means to heat the vaporization tube, wherein

an oxidizing gas can be added to the carrier gas from the gas inlet or the oxidizing gas can be introduced from a primary oxygen supply port.

A thin film formed by using a deposition device having a vaporizer comprising;

① a dispersion part including:

a gas passage formed internally,
a gas inlet to introduce a career gas into the gas passage,
a means to supply the raw material solution to the gas passage,
a gas outlet to send the career gas including the raw material solution to the vaporization part, and
a means to cool the gas passage, and

② a vaporization part for heating and vaporizing the career gas including the raw material solution, sent from the dispersion part, the vaporization part including;

a vaporization tube whose one end is connected to a reaction part of various units such as a deposition, and the other end is connected to the gas outlet, and
a heating means to heat the vaporization tube, wherein

a radiation prevention part having a small hole is installed outside the gas outlet, and
the career gas and an oxidizing gas can be introduced from the gas inlet.

A thin film formed by using a deposition device having a disperser comprising;

a plurality of passages for supplying raw material solution,
a mixture part for mixing a plurality of raw material solutions supplied from a plurality of solution passages,
a supply passage of which one end communicates with the mixture part and has an outlet of the vaporization part side,
a gas passage arranged to spray the career gas or the mixed gas of the career gas and oxygen to the mixture raw material solution carried from the mixture part in the supply passage, and
a cooling means to cool the supply passage.

A thin film formed by using a deposition device comprising:

a disperser, having;
a plurality of solution passages for supplying raw material solution,
a mixture part for mixing a plurality of raw material solutions supplied from a plurality of solution passages,
a supply passage of which one end communicates with the mixture part and has an outlet of the vaporization part side,
a gas passage arranged to spray the career gas or the mixed gas of the career gas and oxygen to the mixture raw material solution from the mixture part, in the supply passage, and
a cooling means to cool the supply passage; and
a vaporizer, having;
a radiation prevention part having a small hole outside the gas outlet, and

a primary oxygen supply port enabling to introduce an oxidizing gas in the direct proximity of the dispersion jet part.

the vaporizer having;

a vaporization part for heating and vaporizing the career gas including the raw material solution, sent from the dispersion part,

a vaporization tube whose one end is connected to a reaction part of various units such as a deposition, and the other end is connected to the outlet of the disperser, and

a heating means to heat the vaporization tube.

A thin film deposited by using a deposition method including a vaporization method; the vaporization method comprising steps of, introducing raw material solution into a gas passage, shearing/atomizing the raw material solution by jetting the career gas to the introduced raw material solution to obtain raw material mist and, then, supplying the raw material mist to a vaporization part for making it vaporize, wherein;

the career gas is made to include oxygen.

Brief Description of Drawings

Fig. 1 is a cross-sectional view showing essential parts of a vaporizer for MOCVD according to an embodiment 1;
Fig. 2 is a global cross-sectional view of the vaporizer for MOCVD according to the embodiment 1;
Fig. 3 is a system chart of MOCVD;
Fig. 4 is a front view of a reserve tank;
Fig. 5 is a cross-sectional view showing essential parts of a vaporizer for MOCVD according to an embodiment 2;
Fig. 6 is a cross-sectional view showing essential parts of a vaporizer for MOCVD according to an embodiment 3;
Fig. 7 (a) and (b) are cross-sectional views showing a variant of a gas passage of a vaporizer for MOCVD, both according to an embodiment 4;
Fig. 8 is a cross-sectional view showing a vaporizer for MOCVD according to an embodiment 5;
Fig. 9 shows a rod used for the vaporizer for MOCVD according to the embodiment 5, (a) is a side view, (b) an X-X cross-sectional view, and (c) a Y-Y cross-sectional view;
Fig. 10 is a side view showing a variant of Fig. 9(a);
Fig. 11 is a graph where the experiment results in embodiment 6 are shown;
Fig. 12 is a side cross-sectional view showing an embodiment 8;
Fig. 13 is a conceptual diagram to show a gas supply system of the embodiment 8;
Fig. 14 is a cross-sectional view showing an embodiment 9;
Fig. 15 is a cross-sectional view showing the nearest prior art;
Fig. 16 (a) and (b) both are cross-sectional views showing the vaporizer for MOCVD of the prior art;
Fig. 17 shows crystallization characteristics of a SBT thin film;
Fig. 18 shows polarization characteristics of the crystallized SBT thin film;
Fig. 19 is a vaporizer detail view;
Fig. 20 is a general view of a vaporizer;
Fig. 21 is an example of SBT thin film CVD unit using a vaporizer;

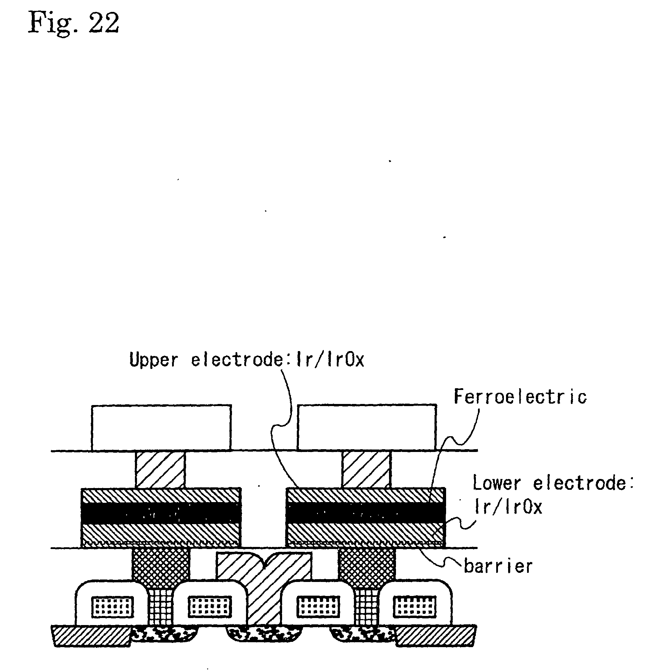

Fig. 22 shows an example of trial manufacture of an integrated circuit FeRAM-LSI equipped with a ferroelectric thin film;

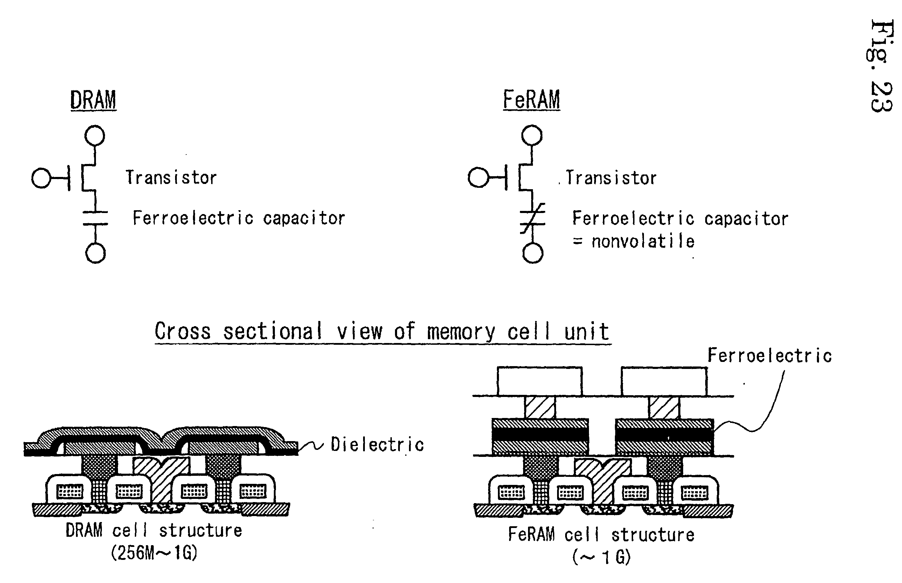

Fig. 23 shows an example of trial manufacture of an integrated circuit DRAM-LSI, equipped with a dielectric substance thin film;

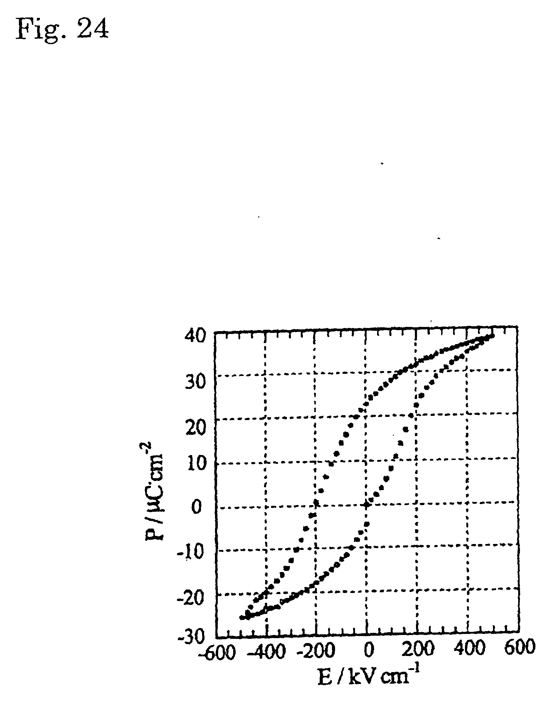

Fig. 24 shows polarization characteristics of a CVDPZT thin film, and

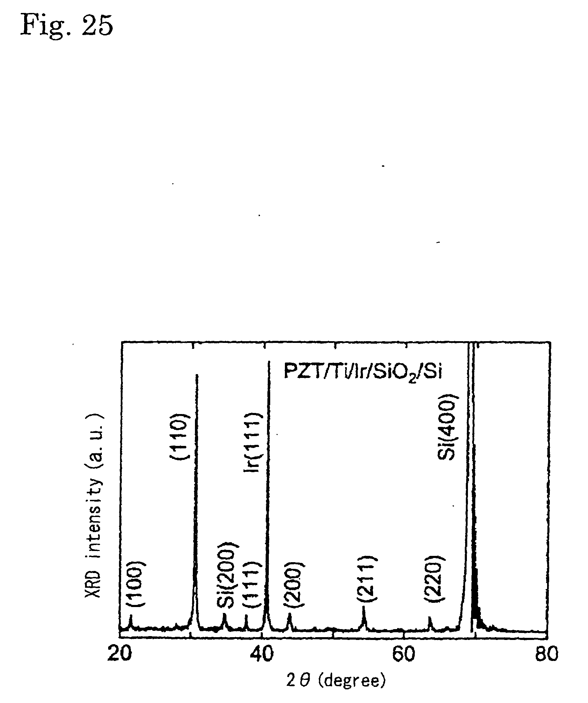

Fig.25 shows a XRD evaluation of a CVDPZT thin film.

Best Mode for Carrying out the Invention

(Embodiment 1)

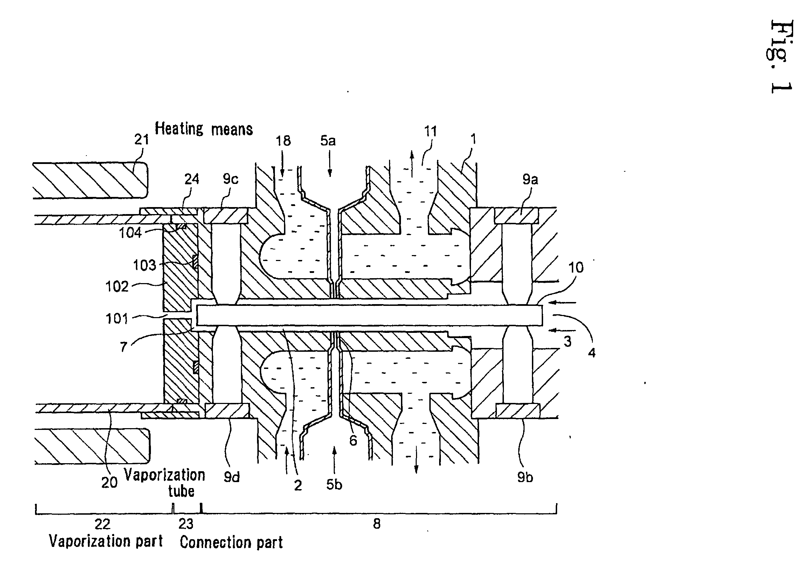

Fig. 1 shows a vaporizer for MOCVD according to an embodiment 1.
This example comprises; a dispersion part 8 including a gas passage 2 formed in the interior of a dispersion main body 1 constituting the dispersion part, a gas inlet 4 to introduce a pressurized career gas 3 into the gas passage 2, a means (a raw material supply hole) 6 to supply a raw material solution 5 to the carrier gas passing through the gas passage 2 and atomize the raw material solution 5, a gas outlet 7 to send the career gas (raw material gas) including the atomized raw material solution 5 to a vaporization part 22, and a means (cooling water) 18 to cool the carrier gas flowing in the gas passage 2; and the vaporization part 22 for heating and vaporizing the career gas, where the raw material solution is dispersed, sent from the dispersion part 8, the vaporization part comprising a vaporization tube 20 whose one end is connected to a reaction pipe of the MOCVD device, and the other end is connected to the gas outlet 7 of the dispersion part 8, and a heating means (heater) 21 to heat the vaporization tube 20, wherein a radiation prevention part 102 having a small hole 101 is provided outside the gas outlet 7.

The cross sectional area of the gas passage is preferably from 0.10 to $0.5mm^2$.

The processing is difficult if less than $0.10mm^2$. The necessity for a large quantity of flow in career gas of the high pressure turns up to be caused to speed up the career gas when exceeding $0.5 mm^2$. A large-scale vacuum pump of large capacity is needed to maintain a reaction chamber under decompression (example: 1.0Torr) when the career gas of a large quantity of flow is used. A proper quantity of flow, that is, the gas passage area of 0.10 to $0.5 mm^2$ is preferable to achieve an industrial practical use because it is difficult to adopt a vacuum pump that exceeds 10,000 liter/min (at1.0Torr) in exhaust capacity.

The gas inlet 4 is installed in one end of the gas passage 2. A career gas (for instance, $N_2$, Ar, and He) source (not shown) is connected to the gas inlet 4.

The raw material supply hole 6 is installed on the side approximately at the middle of the dispersion main body 1 in communication with the gas passage 2, allowing to introduce the raw material solution 5 into the gas passage 2 and dispersing the raw material solution 5 to the career gas that passes through the gas passage 2 to make it the raw material gas.

The gas outlet 7 that leads to the vaporization tube 20 in the vaporization part 22 is installed in one end of the gas passage 2.

A space 11 to flow the cooling water 18 is formed in the dispersion main body 1, and the career gas which flows in the gas passage 2 is cooled by flowing the cooling water 8 in this space. Or, it may be cooled by setting up a Peltier element or the like, for instance, instead of this space. Only the solvent vaporizes in the gas passage 2 without causing the vaporization simultaneously of the solvent of the raw material solution and an organometallic complex in the gas passage 2 that is subjected to the heat influence by the heater 21 of the vaporization part 22. There, the solvent is prevented from being vaporized solely by cooling the career gas, in which the raw material solution is dispersed, flowing in the gas passage 2. Especially, cooling of the downstream side of the raw material supply hole 6 is important, and at least the downstream side of the raw material supply hole 6 is cooled. The cooling temperature is a temperature below the boiling point of the solvent. For instance, it is 67°C or less for THF. Especially, the temperature in the gas outlet 7 is important.

In this embodiment, in addition, the radiation prevention part 102 that has a small hole 101 outside the gas outlet 7 is installed. The numeral 103,104 represent seal materials such as an O ring. This radiation prevention part 102 may be composed, for instance, of teflon, stainless steel, ceramic, etc.. According to the finding of the present inventor, the gas in gas passage 2 is overheated, in the prior art, by the heat in the vaporization part, as the radiant heat through the gas outlet 7. Therefore, the low melting point elements in the gas deposit in the vicinity of the gas outlet 7 even if it is cooled with cooling water 18.

The radiation prevention part is a member to prevent this radiant heat from spreading to the gas. Therefore, it is preferable to reduce the cross sectional area of the small hole 101 less than that of gas passage 2. Reduction of 1/2 or less is preferable and 1/3 or less is more preferable.

Moreover, blockage in the gas passage (especially, gas outlet) with a carbide is never caused even for the long term use, by cooling the dispersion part.

The dispersion main body 1 is connected to the vaporization tube 20 on the downstream side of the dispersion main body 1. The connection between the dispersion main body 1 and the vaporization tube 20 is done with a joint 24, and this part is a connection part 23.

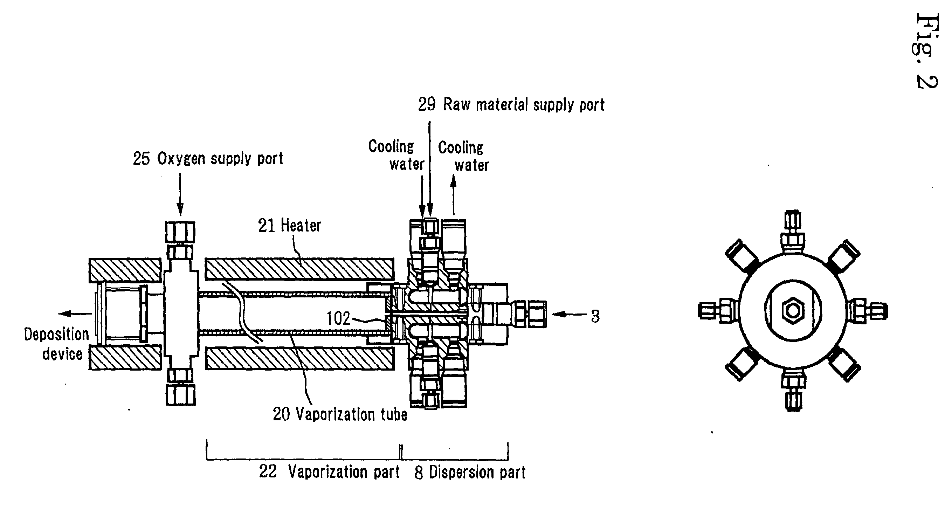

Fig. 2 shows the general view. The vaporization part 22 is composed of the vaporization tube 20 and the heating means 21 (heater). The heater 21 is a heater to heat and vaporize the career gas in which the raw material solution is dispersed that flows in the vaporization tube 20. Though, in the prior art, the heater 21 has been composed by sticking a cylindrical heater or a mantle heater on the outer periphery of the vaporization tube 20. This was adopted because the method of using a liquid or gas with large thermal capacity as heat medium is the most excellent in order to heat to obtain an uniform temperature in the longitudinal direction of the vaporization tube.

It is preferable to use stainless steels such as SUS316L for instance as the vaporization tube 20. The size of the vaporization tube 20 only may be decided conveniently to such a length that the temperature of the vaporization gas is heated sufficiently. For instance, when $SrBi_2Ta_2O_9$ raw material solution 0.04ccm is vaporized, it may be used the one of 3/4 inches in outer diameter and several hundred mm in length.

Though the downstream side edge of the vaporization tube 20 is connected to a reaction tube of the MOCVD device, in this embodiment an oxygen supply port 25 is installed in the vaporization tube 20 as an oxygen supply means, allowing to mix the oxygen heated to a prescribed temperature into the career gas.

First of all, supplying the raw material solution to the vaporizer shall be described.

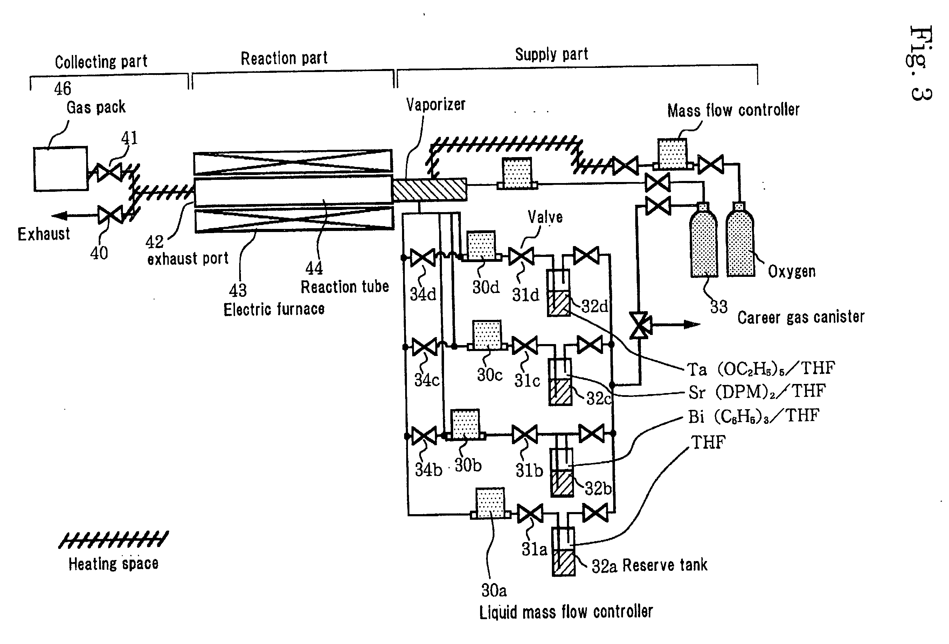

Reserve tanks 32a, 32b, 32c, and 32d are connected to the raw material supply port 6 respectively through mass flow controllers 30a, 30b, 30c, and 30d, and valves 31a, 31b, 31c, and 31d as shown in Fig. 3.

Moreover, each of reserve tanks 32a, 32b, 32c, and 32d is connected to a career gas canister 33.

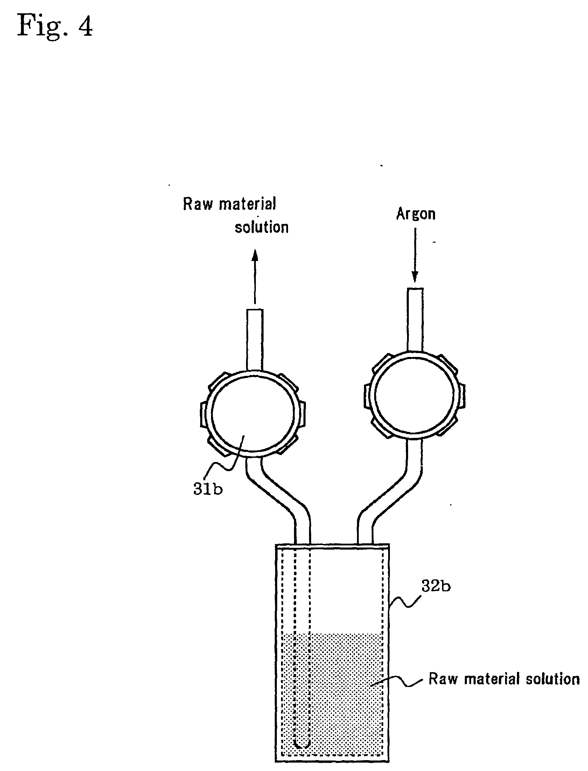

Fig. 4 shows the details of the reserve tank.

The reserve tank is filled with the raw material solution and for instance, 1.0 to 3.0 kgf/cm$^2$ of the career gas (for instance, inert gas Ar, He, Ne) is send to the respective reservoir tank (an inner capacity 300 cc, made by SUS). The raw material solution is pushed up in the tube on the side contacting with the solution, because the interior of the reservoir tank is pressurized by the carrier gas, and transferred under pressure to a mass flow controller (made by STEC, full-scale flow 0.2cc/min), a flowing quantity is controlled here, and it is transported from a raw material supply port 29 of the vaporizer to the raw material supply hole 6.

It is transported to a reaction part by career gas controlled to a constant flowing quantity in the mass flow controller. At the same time, oxygen (oxidant) which is controlled to a fixed flowing quantity in a mass flow controller (made by STEC, full-scale flow 2L/min) is also transported to the reaction part.

The raw material solution deposits an organometallic complex by the vaporization of THF solvent and becomes finally solid when left as it is, because a liquid or a solid organometallic complex has been dissolved in solvent such as THF at the normal temperature. Therefore, it is assumed as a result that the interior of a piping that comes in contact with a stock solution to cause the blockage or others of the piping by this. Therefore, it is thought that it only has to wash the interior of the piping and the interior of the vaporizer with THF or other solvents after the deposition work end to control the blockage of the piping, and to install a washing line. Washing is exerted over a part from the container outlet side to the vaporizer including the raw material container exchange work, and flushes the part which suits each work with the solvent.

Valves 31b, 31c, and 31d were opened, and the career gas was fed forcefully into the reserve tank 32b, 32c, and 32d. As for the raw material solution, it is fed forcefully to the mass flow controller (made by STEC full-scale flowing quantity 0.2cc/min), a flowing quantity is controlled here, and the solution raw material is transported to the raw material supply hole 6 of the vaporizer.

On the other hand, the career gas was introduced from the gas inlet of the vaporizer. It is preferable to set the maximum pressure on the supply port side to 3kgf/cm$^2$ or less, and the maximum flowing quantity which can be passed at this time is about 1200cc/min, and the passage flow velocity of the gas passage 2 reaches one hundred and tens m/sec.

When the raw material solution is introduced from the raw material supply hole 6 into the career gas flowing in the gas passage 2 of the vaporizer, the raw material solution is shorn by a high speed flow of the carrier gas, and atomized into ultrafine particle. As a result, the raw material solution is dispersed in the career gas in the state of ultrafine particle. The career gas (raw material gas) in which the raw material solution is dispersed in the state of ultrafine particle is atomized, keeping the high-speed, into the vaporization part 22 and discharged. An angle which the gas passage and the raw material supply hole form is optimized. When a career passage and a raw material solution inlet form an acute angle (30 degrees), the solution is attracted by the gas. If it is 90 degrees or more, the solution is pushed by the gas. The best angle is decided, from the viscosity and the flowing quantity of the solution. The solution flows smoothly by making it more acute when the viscosity and the flowing quantity are large. When the SBT film is formed by using hexane-for the solvent, about 84 degrees are preferable because both the viscosity and the flowing quantity are small.

Three kinds of raw material solutions controlled to a constant flowing quantity flow into the gas passage 2 from the raw material supply hole 6 through each raw material supply port 29, move in the gas passage with the career gas which became a high-speed current of air, before being discharged into the vaporization part 22. For the dispersion part 8 also, as the raw material solution is heated by heat from the vaporization part 22 and the vaporization of the solvent such as THF is promoted, the part from the raw material supply port 29 to the raw material supply hole 6 and the part of gas passage 2 are cooled with water or others.

The raw material solution dispersed in the state of fine particle in the career gas discharged from dispersion part 8 becomes a mixture gas by mixing the oxygen heated at a prescribed temperature from the oxygen supply port 25 installed immediately before reaching a reaction tube of MOCVD, the vaporize being promoted while transporting inside the vaporization tube 20 heated by a heater 21 to a prescribed temperature, and flows in a reaction tube. In this embodiment, it is evaluated by analyzing the reactive mode of the vaporization gas in place of deposition.

A vacuum pump (not shown) was connected from an exhaust port 42, impurities such as moisture in a reaction tube 44 were removed by the decompression operation for about 20 minutes, and a valve 40 downstream the exhaust port was shut.

The cooling water was flowed into the vaporizer by about 400cc/min. On the other hand, the career gas of 3kgf/cm$^2$ was flowed by 495cc/min, the interior of the reaction tube 44 was filled enough with the career gas, and thereafter, the valve 40 was opened. The temperature at the gas outlet 7 was lower than 67°C.

The inside of the vaporization tube 20 was heated to 200°C, the part from the reaction tube 44 to a gas pack 46 and the gas pack to 100°C, and the inside of the reaction tube 44 from 300 to 600°C.

The reserve tank was pressurized with the career gas therein, and a prescribed liquid was flowed by the mass flow controller.

Sr(DPM) 2, Bi($C_6H_5$)$_3$, Ta($OC_2H_5$)$_5$, and THF were flowed respectively by the flowing quantity of 0.04cc/min, 0.08cc/min, 0.08cc/min, and 0.2cc/min.

Twenty minutes later, the valve just before the gas pack 46 was opened, the reaction product was collected in the gas pack 46 and it was examined whether the detected product and the product in the reaction formula that has been examined based on the reaction theory agree, through analysis by the gas chromatograph. As a result, the detected product and the product in the reaction expression that had been examined based on the reaction theory agreed well in this example.

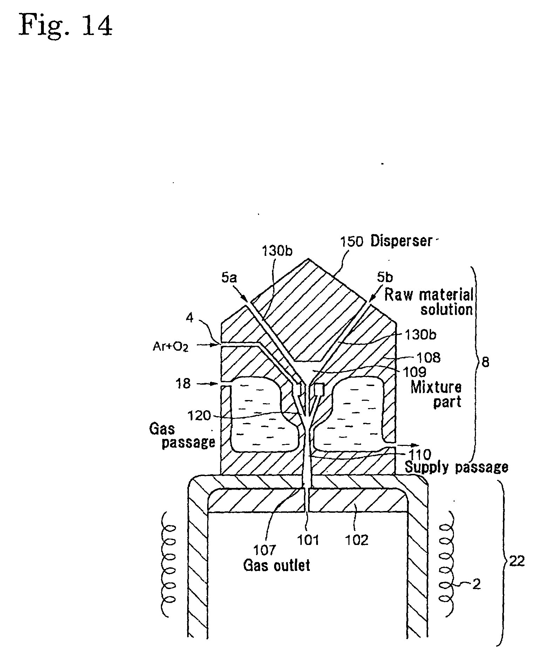

Moreover, the amount of adhesion of the carbide on the outer surface of the gas outlet 7 side was measured. As a result, the amount of adhesion of the carbide was very low, and was still less than the case with a device shown in Fig. 14.

It is general that the raw material solution becomes a liquid/liquid state (complete solvent liquid) with metals becoming complex, in case of mixture or dissolution of metals becoming a film raw into the solvent to obtain a raw material solution. However, the present inventor elaborately examined the raw material solution, and found that the metal complex does not necessarily come to separate molecular state but, in some cases, the metal complex might exist in the solvent as particle of the size of 1 to 100nm, and in some cases, the metal complex might exist partially as solid/liquid state. It is thought that clogging during the vaporization is especially caused easily when the raw material solution is in such a state; however, the clogging is not caused even for a raw material solution is such a state, in case of using a vaporizer of the present invention.

Moreover, the fine particle subsides easily by gravity to the bottom in a solution where the raw material solution subsists. Then, it is desirable to cause convection and uniform dispersion of fine particle in the preservation solution by heating the bottom (below the vaporization point of the solvent to the last) in respect of clogging prevention. Moreover, it is more preferable to heat the bottom and to cool the side on the container top. Of course, they shall be heated at the temperature below the vaporization temperature of the solvent.

(Embodiment 2)

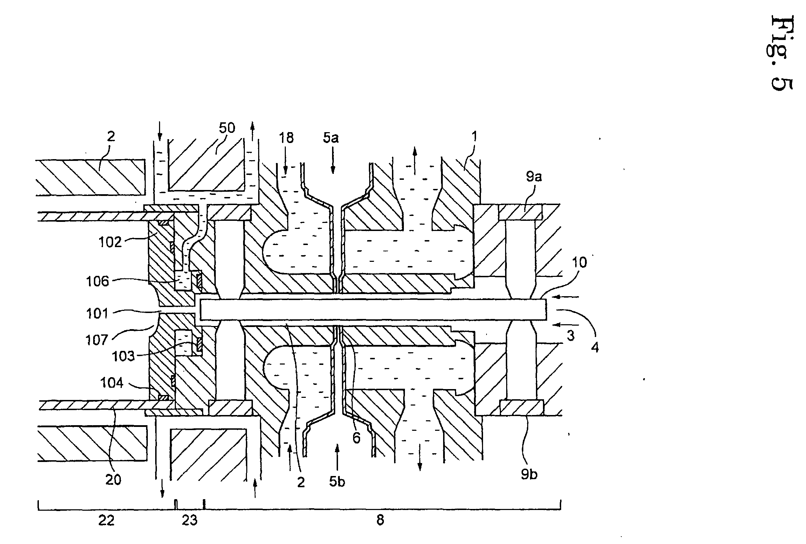

Fig. 5 shows the vaporizer for MOCVD according to the embodiment 2.

In this embodiment, a cooling water passage 106 was formed around the outer periphery of the radiation prevention part 102, and cooling means 50 was installed around the outer periphery of a connection part 23, and radiation prevention part 102 was cooled.

Moreover, a hollow 107 was installed around the outlet of the small hole 101.

Other respects were made similar to the embodiment 1.

In this embodiment, the detected product agrees with the product in the reaction formula that had been examined based on the reaction theory better than that of the embodiment 1.

Moreover, the amount of adhesion of the carbide was about 1/3 times of the case of the embodiment 1, as the result of the measurement of the amount of adhesion of the carbide of on the outer surface on the gas outlet 7 side of the dispersion main body 1.

(Embodiment 3)

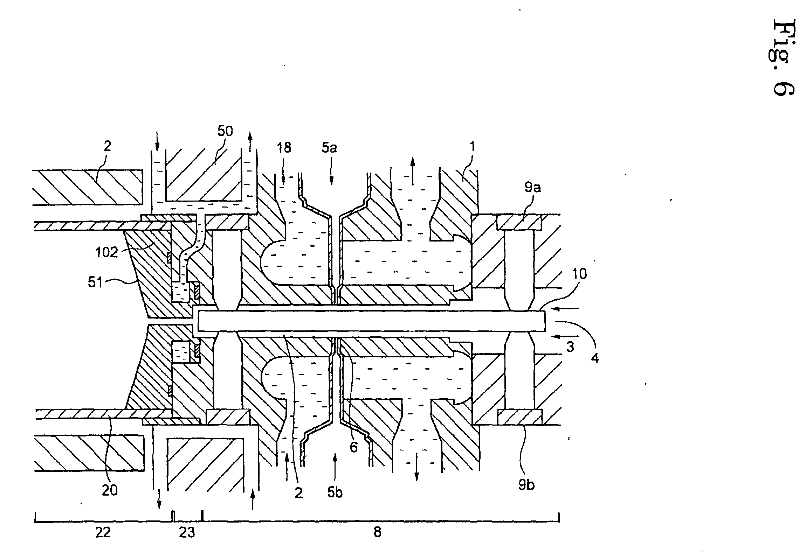

Fig. 6 shows the vaporizer for MOCVD according to the embodiment 3.

In this embodiment, taper 51 is installed in radiation prevention part 102. Dead zone in the concerned part disappears because of this taper 51, and the stagnation of raw material can be prevented.

Other respects were made similar to the embodiment 2.

In this embodiment, the detected product agrees with the product in the reaction formula that had been examined based on the reaction theory better than that of the embodiment 2.

Moreover, the amount of adhesion of the carbide was almost null, as the result of the measurement of the amount of adhesion of the carbide of on the outer surface on the gas outlet 7 side of the dispersion main body 1.

(Embodiment 4)

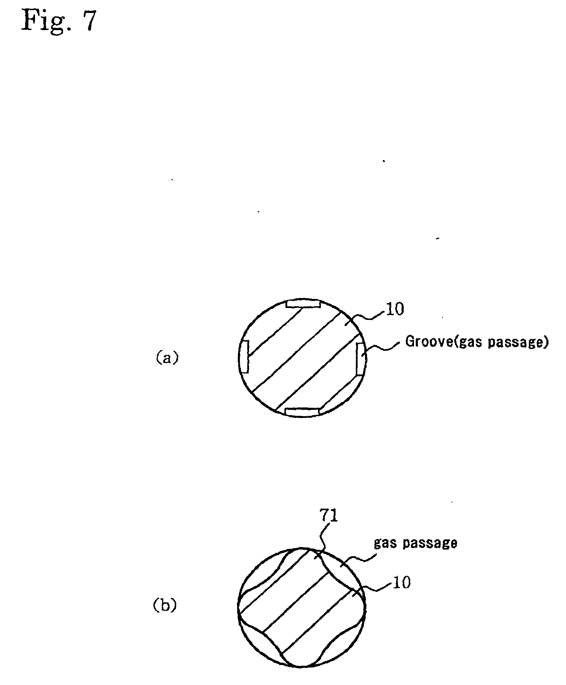

Fig. 7 shows the modification embodiment referring to the gas passage.

The groove 70 is formed on the surface of a rod 10, and the outer diameter of rod 10 is made substantially the same as the inner diameter of the hole perforated in the inside of the dispersion main body 1 in Fig. 7(a). Therefore, the rod 10 can be disposed in the hole without deviation only by setting the rod 10 in the hole. Moreover, a screw etc. need not be used. This groove 70 becomes the gas passage.

Note that a plurality of grooves 70 may be formed in parallel to the longitudinal central axis of the rod 10 or spirally on the surface of the rod 10. Spiral grooves can make a raw material gas more uniform.

Fig. 7(b) is an example of installing the mixture part in the tip part of the rod 10. The largest diameter of the tip part is made almost the same as the diameter of the hole perforated in the interior of the dispersion main body 1. The space formed by the tip part of the rod and the inner face of the hole becomes a gas passage.

Obviously, the gas passage may be formed by using the rod of a circular cross section as a rod and installing a concave portion in the hole, though the example shown in (a) and (b) is an example of executing the processing to the surface of the rod 10. It is preferable to set up the rod with about H7×h6 to JS7 provided by JIS for instance.

(Embodiment 5)

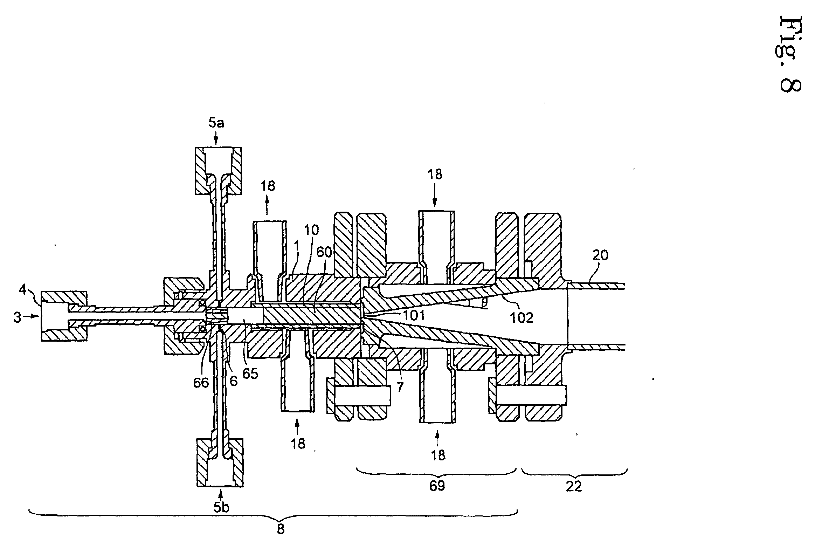

The embodiment 5 shall be described based on Fig. 8.

The vaporizer for MOCVD of this embodiment has a dispersion part 8 including a gas passage formed internally, a gas inlet 4 to introduce a pressurized career gas 3 into the gas passage, a means to supply the raw material solution 5a, 5b to the gas passage, and a gas outlet 7 to send the career gas including the raw material solution 5a, 5b to the vaporization part 22; and a vaporization part 22 for heating and vaporizing the career gas including the raw material solution, sent from the dispersion part 8, the vaporization part 22 comprising; a vaporization tube 20 whose one end is connected to a reaction part of the MOCVD unit, and the other end is connected to the gas outlet 7, and a heating means to heat the vaporization tube 20, wherein the dispersion part 8 comprises a dispersion main body 1 having a cylindrical hollow part and a rod 10 having an outer diameter smaller than the inner diameter of the cylindrical hollow part, the rod 10 has one or more spiral groove(s) 60 on the vaporizer 22 side of the outer periphery of the rod, and the rod 10 is inserted in the cylindrical hollow part, and a radiation prevention part 101 having a small hole 101 and an inner diameter expanding in taper towards the vaporizer 22 side is installed outside the gas outlet 7.

When the raw material solution 5 is supplied to the gas passage where high-speed career gas 3 flows, the raw material solution is shorn and atomized. That is, the raw material solution that is liquid is shorn by the high speed flow of the career gas, and made into particle. The raw material solution made into particle is dispersed in the career gas in the state of particle. This respect is similar to the embodiment 1.

The following conditions are preferable to execute shearing and atomization optimally.

It is preferable to supply raw material solution 5 by 0.005 to 2cc/min, preferably by 0.005 to 0.02c/min, and more preferably by 0.1 to 0.3cc/min. When two or more raw material solutions (containing solvent) are supplied at the same time, it concerns their total amount.

Moreover, it is preferable to supply the career gas at the speed of 10 to 200m/sec, and 100 to 200m/sec is more preferable.

Obviously, the flowing quantity of the raw material solution and the flowing quantity of the career gas are correlated, and the passage sectional area and shape shall be selected for the best achievement of shearing and atomization so that ultrafine particle mist be obtained.

In this embodiment, spiral grooves 60 are formed around the outer periphery of the rod 10 and gap space exists between the dispersion main body 1 and the rod 10; consequently, the career gas including the raw material solution that became the atomized state goes straight in this gap space as a straightly advancing flow, and at the same time, forms a rotating flow along the spiral groove 60.

Thus, the present inventor found that the raw material solution atomized in a state where the straightly advancing flow and the rotating flow are concomitant is uniformly dispersed in the career gas. The reason why a uniform dispersion can be realized when the straightly advancing flow and the rotating flow are concomitant is not necessarily clear; however it can be supposed as follows. By the existence of the rotating flow, the centrifugal force works on the flow, and the secondary flows are caused. The mixture of the raw material and the career gas is promoted by these secondary flows. That is, a secondary derivation flow is caused by the centrifugal effect of the rotating flow in a perpendicular direction to the flow, and, as a result, it seems that the atomized raw material solution is dispersed more uniformly in the career gas.

Now, this embodiment shall de described more in detail as follows.

In this embodiment, it is composed to supply four kinds of raw material solutions 5a, 5b, 5c, and 5d (5a, 5b, and 5c are organometallic raw materials and 5d is a solvent raw material such as THF) to the gas passage as one example.

In order to mix the career gas (called, "raw material gas") including the raw material solution that became respectively mist and ultrafine particle, a part without spiral groove is installed in the downstream of the portion corresponding to the raw material supply hole 6 of the rod 10, in this embodiment. This portion becomes a pre-mixing part 65. In the pre-mixing part 65, the raw material gases of three kinds of organic metals are mixed to some degree, and, in addition, becomes a complete mixture raw material gas in an area of helical structure in the downstream thereof. As for the length of this mixing part 65, 5 to 20mm is preferable, and 8 to 15mm is more preferable to obtain a uniform mixture raw material gas. Outside this range, a mixture raw material gas in which only one kind of the three organometallic raw material gasses is denser than two other organometallic raw material gasses might be sent to the vaporization part 22.

In this embodiment, a parallel part 67 and a taper part 58 are installed at an edge 66 on the upstream side of the rod 10. The cylinder hollow part of the dispersion main body 1 is provided with a parallel part having the same inner diameter as the outer diameter of the parallel part 67 of the rod 10, and a taper part that is the same taper as the taper of the rod 10 corresponding to the parallel part 67 and the taper part 58. Therefore, if the rod 10 is inserted from the top left side on the drawing, the rod 10 is maintained in the hollow part of the dispersion main body 1.

Different from the embodiment 1, even if a career gas of a higher pressure than $3kgf/cm^2$ is used, the rod 10 can prevent from being moved, because the taper is provided to hold the rod 10, in this embodiment. That is, if the maintenance technology shown in Fig. 8 is adopted, the career gas can be flowed at a pressure of $3kg/cm^2$ or higher. As a result, it becomes possible to reduce the sectional area of the gas passage, and supply a higher speed career gas with a small amount of gas. That is, the supply of a high-speed career gas at 50 to 300mm/sec becomes possible, too. If this maintenance technology is adopted, it is similar also for the aforementioned other embodiments.

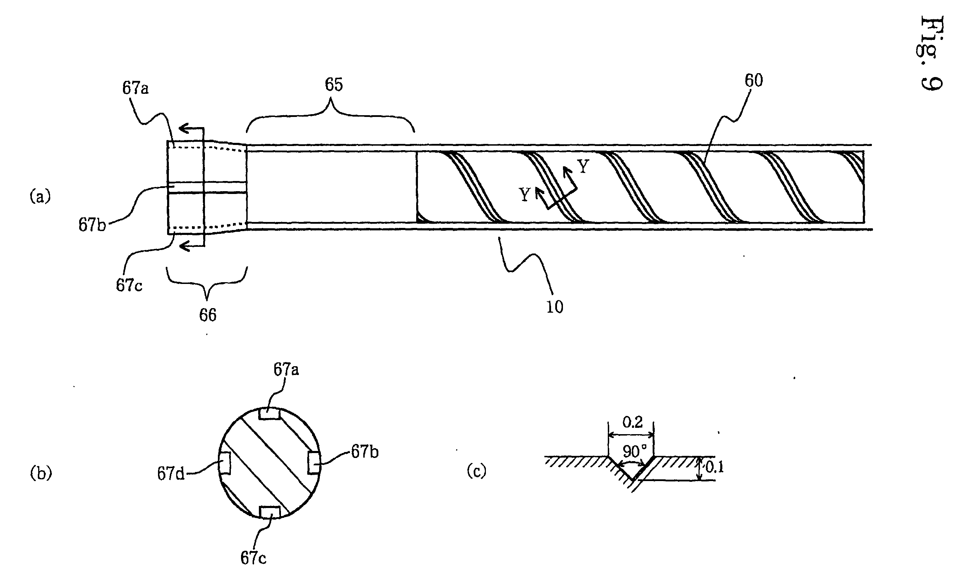

The grooves 67a, 67b, 67c, and 67d are formed as a passage of the career gas, in a portion corresponding to the raw material supply hole 6 of the rod 10, as shown in Fig. 9(b). 0.005 to 0.1mm is preferable as the depth of each groove 67a, 67b, 67c and 67. Molding of the groove becomes difficult if less than 0.005mm. Moreover, 0.01 to 0.05 is more preferable. The clogging or other is not generated by making it within this range. Moreover, it is easy to obtain a high-speed flow.

The composition shown in Fig. 1 for the embodiment 1 and other compositions may be adopted for the maintenance of the rod 10 and the formation of the gas passage.

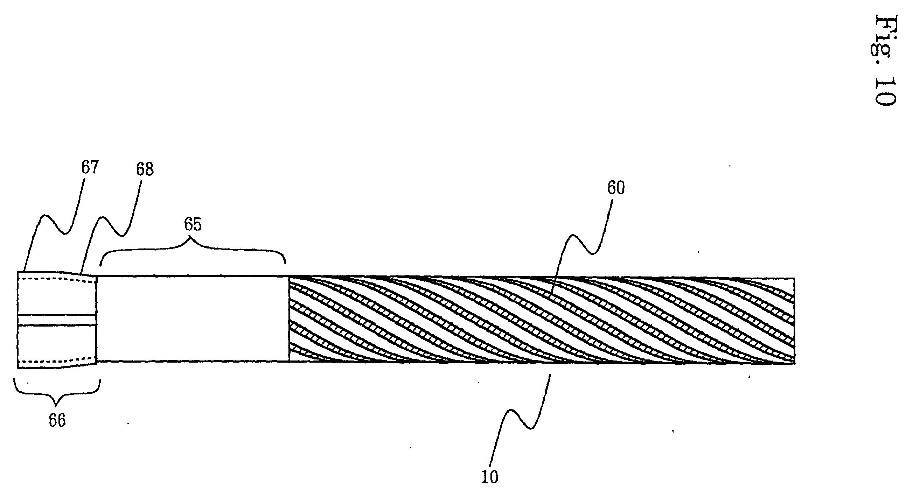

The number of spiral groove 60 may be single as shown in Fig. 9(a) but it may also be two or more as shown in Fig. 10. Moreover, they may be crossed when two or more spiral grooves are formed. The raw material gas dispersed more uniformly is obtained when they are crossed. However, a cross sectional area of each groove is set to allow the gas flow velocity to be 10m/sec or more.

The size and shape of the spiral groove are not especially limited, and the size and shape shown in Fig. 9(c) are raised as one example.

In this embodiment, the gas passage is cooled with cooling water 18 as shown in Fig. 8.

Moreover, an expansion part 69 is independently installed in this side of the entrance of dispersion part 22 in this embodiment, and a longitudinal radiation prevention part 102 is arranged in this expansion part. A small hole 101 is formed on the gas outlet 7 side of the radiation prevention part, and its inner diameter spreads out in the taper-shape toward the vaporizer side.

This expansion part 69 is also a portion to prevent the stay of the raw material gas described for the embodiment 3. Of course, the expansion part 69 need not be independently installed, and an integrated composition as shown in Fig. 6 may also be adopted.

An angle of from 5 to 10 degrees is preferable as the expansion angle θ for the expansion part 69. The raw material gas can be supplied to the dispersion part without destroying the rotating flow when θ is in this range. Moreover, when θ is within this range, the fluid drag by the expansion is minimized, the existence of dead is minimized, and the existence of vortex by the existence of the dead zone can be minimized. Note that the angle of from 6 to 7 degrees is more preferable as θ. The range of preferable θ is similar also in the embodiment shown in Fig. 6.

(Embodiment 6)

The raw material solution and the career gas were supplied under the following conditions, using the device shown in Fig. 8, and the uniformity in the raw material gas was examined.

| | |
|---|---|
| Amount of introduced raw material solution: $Sr(DPM)_2$ | 0.04cc/min |
| $Bi(C_6H5)_3$ | 0.08cc/min |
| $Ta(OC_2H_5)_5$ | 0.08cc/min |
| THF | 0.2cc/min |

Career gas: Nitrogen gas

10～350m/s

The device shown in Fig. 8 was used as the vaporization device. However, the rod where a spiral groove was not formed as shown in Fig. 9 was used as a rod.

The raw material solution is supplied from the raw material supply hole 6, while the career gas is changed in speed variously. The groove 67a was supplied with $Sr(DPM)_2$, groove 67b with $Bi(C_6H_5)_3$, groove 67c with $Ta(OC_2H_5)_5$ and groove 67d with solvent such as THF respectively from the raw material supply hole.

Heating in the vaporization part was not executed, the raw material gas was collected at the gas outlet 7, and the particle diameter of the raw material solution was measured in the collected raw material gas.

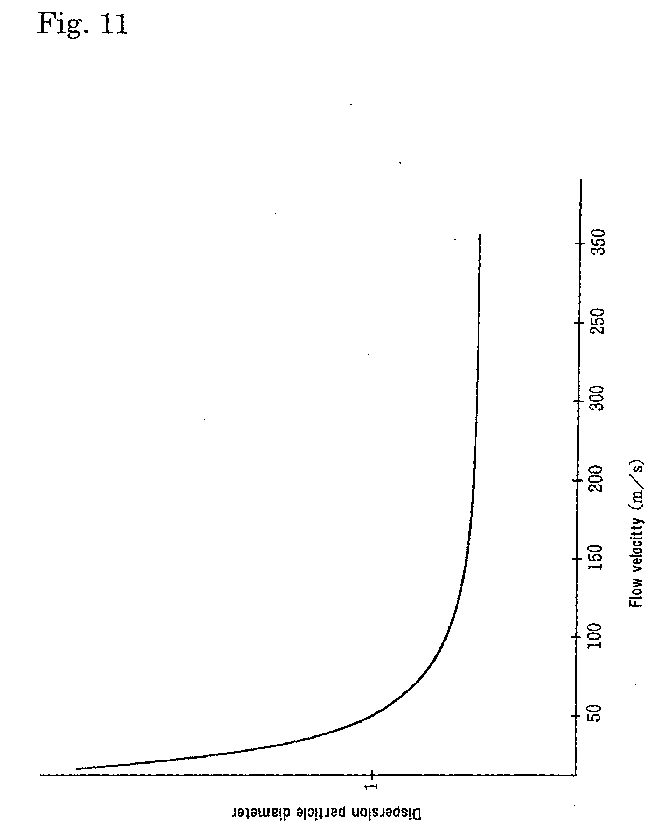

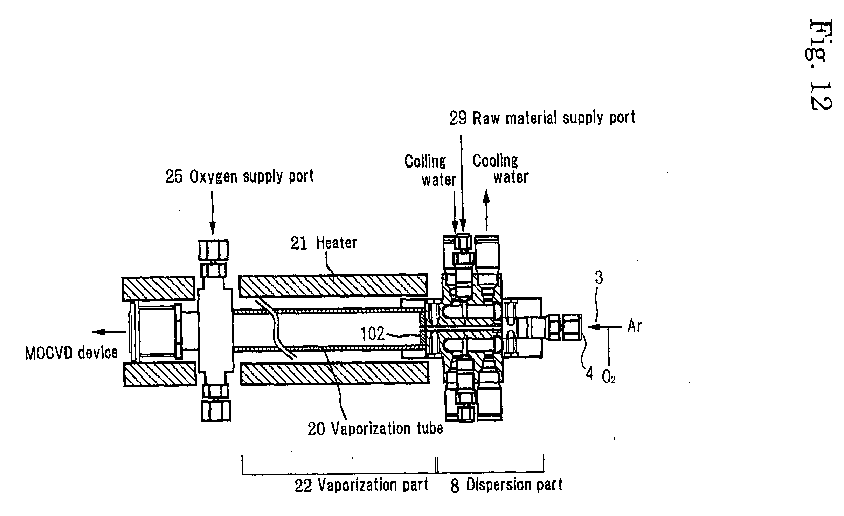

The results are shown in Fig. 11 as relative values (the case with a device according to an example of the prior art shown in Fig. 12(a) is set to be 1). The dispersion particle diameter becomes smaller by setting the flow velocity to 50m/sec or more as understood from Fig. 11, and the dispersion particle diameter becomes still smaller by setting the flow velocity to 100m/sec or more. However, the dispersion particle diameter is saturated even if set to 200m/sec or more. Therefore, 100 to 200m/sec is a more preferable range.

(Embodiment 7)

In this embodiment, a rod where a spiral groove had been formed was used as a rod.

Other respects were the same as the embodiment 6.

The density of the raw material solution that had been supplied to the groove was high in the groove extension part, in the embodiment 6. That is, respectively the density of one raw material solution was higher than others in each extension part of the groove through it came; the density of $Sr(DPM)_2$ was higher than that of the others in the extension part of the groove 67a, $Bi(C_6H_5)_3$ in the extension part of the groove 67b and $Ta(OC_2H_5)_5$ in the extension part of the groove 67c.

However, in this embodiment, each organometallic raw material of the mixture raw material gas that had been obtained on the edge of a spiral groove was uniform in any part.

(Embodiment 8)

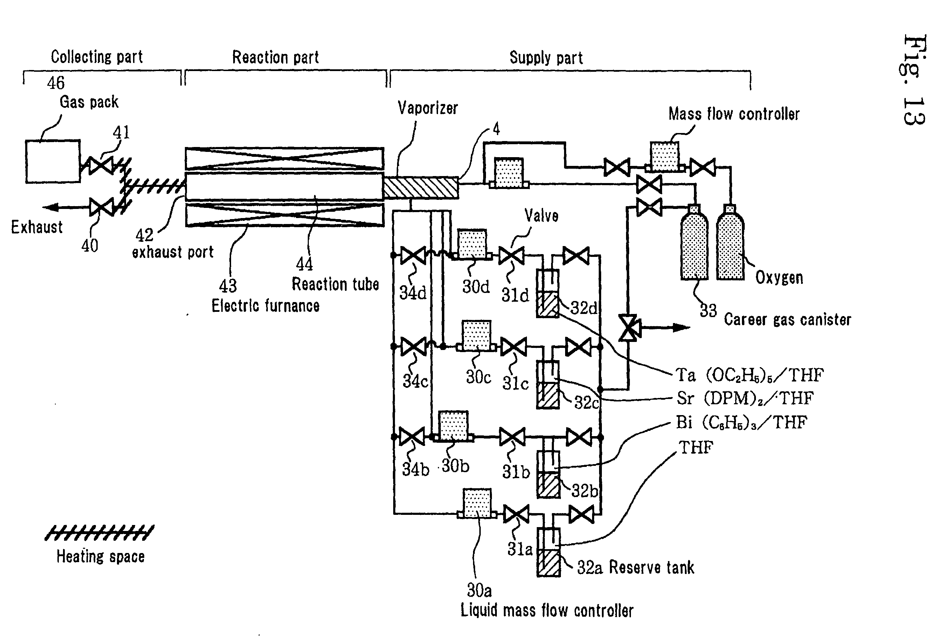

Fig. 12 and Fig. 13 show the embodiment 8.

Oxygen had been introduced only downstream the vaporization part 22 as shown in Fig. 2 in the prior art. As described in the column of the prior art, a large amount of carbon is contained in the film formed by the prior art. Moreover, there was a difference between the composition allocation in the raw material and the composition allocation in the deposited film. That is, when the raw material was adjusted to the composition ratio of the stoichiometric mixture ratio, vaporized, and deposited, the actually deposited film turned out a composition film deviated from the stoichiometric mixture ratio. Especially, a phenomenon that bismuth is hardly included (about 0.1 at%) was observed.

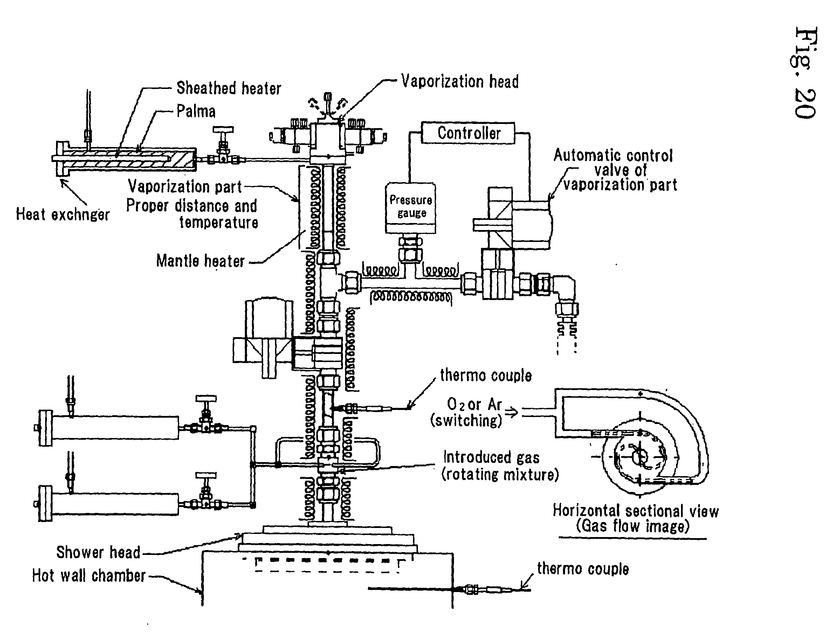

The present inventor found the cause thereof relating to the position where oxygen was introduced. That is, it has understood that, if oxygen is introduced from the gas inlet 4, a secondary oxygen supply port 200 nearest the jet port, and the oxygen inlet 25(first oxygen supply port) with the career gas as shown in Fig. 20, the difference of composition ratio between the composition in the formed film and the composition in the raw material solution can be extremely minimized.

The career gas and oxygen may be mixed beforehand, and their mixed gas may be introduced from the gas inlet 4.

(Embodiment 9)

This embodiment is an example of forming ferroelectric SBT film.

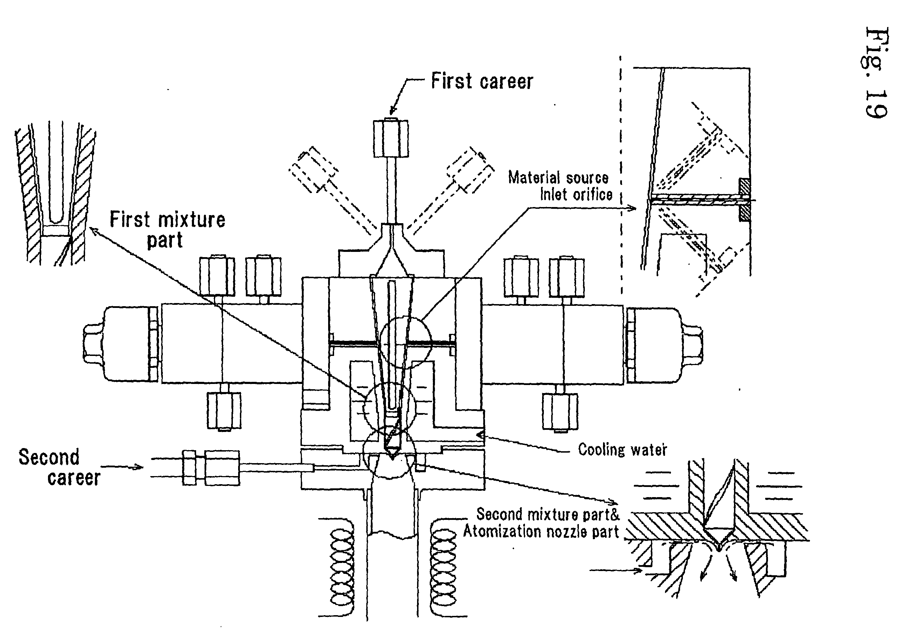

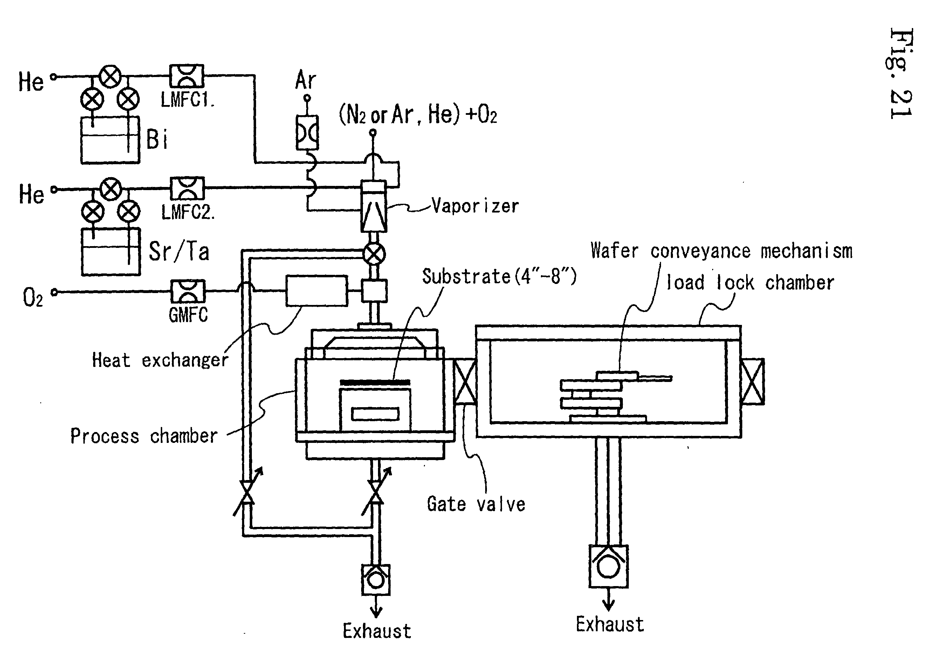

The SBT film was formed by a vaporizer shown in Fig. 19 and 20, and a CVD device shown in Fig. 21, and then the polarization characteristic and others were evaluated.

More concretely, the vaporizer condition and the reaction chamber condition were controlled as follows, and the SBT thin film was formed on a substrate that applied platinum 200nm on an oxidized silicon substrate body.

Concrete conditions:

Hexaethoxy strontium tantalum $Sr[Ta(OC_2H5)_6]_2$ 0.1 mole solution (Solvent: Hexane) 0.02ml/min
Tori-t-amyloxide bismuth $Bi(O-t-C_5H_{11})_3$ 0.2 mole solution (Solvent: Hexane) 0.02ml/min
First career Ar=200sccm (introduced into the gas inlet 4)
First career $O_2$=10sccm (introduced into the gas inlet 4)
Second career Ar=20sccm (introduced into the gas inlet 200)
Second career $O_2$=10sccm (introduced into the gas inlet 200)
Reactant oxygen $O_2$=200sccm (introduced into lower part 25 of the dispersion jet part)

Reactant oxygen temperature 216°C (control the temperature by a separately installed heater before introducing from the lower part of the dispersion jet part)

| | |
|---|---|
| Wafer temperature | 475°C |
| Space temperature | 299°C |
| Space distance | 30mm |
| Temperature of shower head | 201°C |
| Reaction pressure | 1Torr |
| Deposition time | 20 minutes |

As a result,

| SBT film thickness about 300nm (depositing speed about 150nm/min) | | |
|---|---|---|
| SBT composition | Sr | 6.9 at% |
| | Bi | 14.1 at% |
| | Ta | 14.1 at% |
| | O | 61.4 at% |
| | C | 3.5 at% |

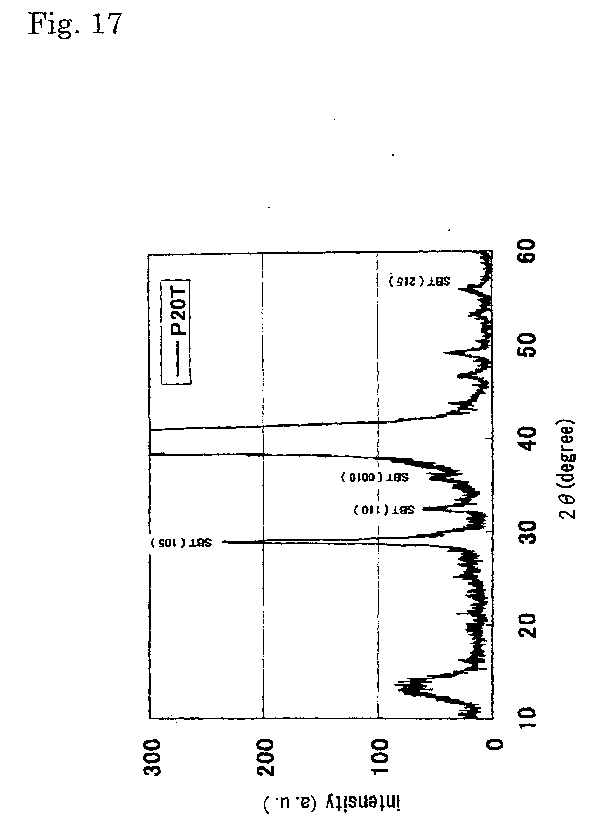

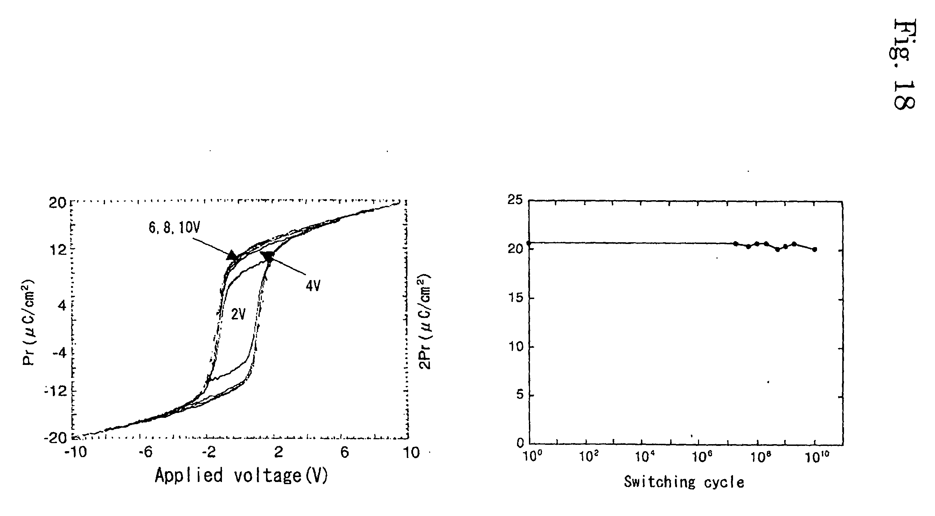

The difference of the composition ratio between the composition in the formed film and the composition in the raw material solution was small, and the depositing speed became about five times as fast as that of the prior art. It can be said that it is extremely effective to introduce a small amount of oxygen from the gas inlet 4 with the career gas. The content of the carbon is low as 3.5 at%. A large effect of controlling re-condensation/ sublimation (solidification) of the vaporized organometallic compound was confirmed by the fact that the dirt disappeared from lower part of the vaporization tube, because the temperature of the reactant oxygen 200cc/min was accurately controlled (at 216°C) by a separately installed heater before the reactant oxygen was introduced from the lower part of the dispersion jet part. After the SBT thin film had been formed, it was put under the crystallization process at 550°C for 30 minutes under the oxygen atmosphere to form an upper electrode, and then excellent crystallization and polarization characteristics were found by the measurement and the evaluation. This is shown in Fig. 17 and 18.

As shown in Fig. 2, it is preferable to control the amount of oxygen appropriately by introducing oxygen simultaneously to the downstream of the vaporization part in order to reduce the difference of the composition ratio, and to decrease the carbon content, provided that oxidizing gas such as oxygen is introduced from the gas inlet 4 or the primary oxygen supply port closest to the jet port.

The content of carbon in the formed film can be decreased by 5 to 20% compared to the prior art.

The SBT thin film deposition process shall be described by using Fig. 20.

The valve 2 is opened, the valve 1 is shut, and a few minutes after the reaction chamber is drawn to the high vacuum, the wafer is transferred from the loading lock chamber to the reaction chamber. At this moment,
Hexaethoxy strontium tantalum $Sr[Ta(OC_2H5)_6]_2$ 0.1 mole solution (Solvent: Hexane) 0.02ml/min
Tori- t-amyloxide bismuth $Bi(O-t-C_5H_{11})_3$ 0.2 mole solution (Solvent: Hexane) 0.02ml/min
First career Ar=200sccm (introduced into the gas inlet 4)
First career $O_2$=10sccm (introduced into the gas inlet 4)
flow into the vaporizer, and are drawn to the vacuum pump via the valve 2 and the automatic pressure regulating valve.

The pressure gauge is controlled by the automatic pressure regulating valve to 4Torr, at this time.

A few minutes after the wafer is transferred, if the temperature is steady, the following gas flows into the reaction chamber thereof the valve 1 opened and the valve 2 shut to start depositing.
Hexaethoxy strontium tantalum $Sr[Ta(OC_2H5)_6]_2$ 0.1 mole solution (Solvent: Hexane) 0.02ml/min
Tori- t-amyloxide bismuth $Bi(O-t-C_5H_{11})_3$ ·0.2 mole solution (Solvent: Hexane) 0.02ml/min
First career Ar=200sccm (introduced into the gas inlet 4)
First career $O_2$=10sccm (introduced into the gas inlet 4)
Second career Ar=20sccm (introduced into the gas inlet 200)
$O_2$=10sccm (introduced into the gas inlet 200)
Reactant oxygen $O_2$=200sccm (introduced into the lower part 25 of the dispersion jet part)

Reactant oxygen temperature 216°C (control the temperature by a separately installed heater before introducing from the lower part of the dispersion jet part)

Wafer temperature 475°C

The pressure of the reaction chamber is controlled at 1Torr (by an automatic pressure regulating valve not shown).

When a required time (in this case 20 minutes) has passed, the valve 2 is opened and the valve 1 is shut to terminate the deposition.

One minute after the gas in the reaction chamber is drawn to a high vacuum to remove the reactant gas completely, the wafer is taken out to the loading lock chamber.

Since vaporization gas in which an organometallic material is uniformly dispersed can be obtained and solid material is dissolved into solvent to vaporize according to the embodiment shown above, thereby a ferroelectric thin film of high quality can be made with a good reproducibility.

For a conductor thin film, a metallic thin film, and the oxide conductor thin film as well, thin film of the high quality can also be made with a good reproducibility just as the above embodiment by using the solid material.

Dielectric substance thin film SBT, STO, and TaOx

Metallic thin film Ir, Ru, Cu, Ti, TiN, Ta, TaN, and SRO

Oxide conductor thin film Ir, IrOx, Ru, and RuOx

Table 2 shows the characteristics of the raw material of dielectric substance thin film, metallic thin film, and oxide conductor thin film.

One example is shown in the following.

Table 2

| Characteristics of raw material of dielectric substance thin film, metallic thin film, and oxide conductor thin film | | |
| --- | --- | --- |
| | Boiling point ($\square$) /pressure(mmHg) | Melting point($\square$) |
| $Sr(DPM)_2$ | 231/0.1 | 231 |
| $Ba(C_6H_5)_3$ | 130/0.1 | 80 |
| $Ti(OiPr)_4$ | 35/0.1 | 20 |
| $Ta(OC_2H_5)_5$ | 118/0.1 | 22 |
| $Sr(Ta(OEt)_6)_2$ | 176/0.1 | 130 |
| $Bi(OtAm)_3$ | 87/0.1 | 90 |
| $Ir(EtCp)(cod)$ | 105/0.1 | 14 |
| $Ru(EtCp)_2$ | 73/0.1 | 6 |
| THF | 67 | -109 |

(Embodiment 10)

This embodiment shows an example of forming a SBT thin film and making an electronic device for trial manufacture.

The SBT film was formed using the vaporizer shown in Fig. 19 and 20 and the CVD device shown in Fig. 21, and then the dielectric constant and others were evaluated. Concretely, conditions of the vaporizer and the reaction chamber conditions were controlled as follows, and the SBT thin film was formed on the substrate that applied platinum 200nm on an oxidized silicon substrate body.

Concrete conditions:

Hexaethoxy strontium tantalum Sr $[Ti(OC_2H_5)_6]_2$ 0.1 mole solution (Solvent: Hexane) 0.02ml/min

Tori- t-amyloxide barium $Ba(O-t-C_5H11)_3$ 0.2 mole solution (Solvent: Hexane) 0.02ml/min

First career Ar=200sccm (introduced into the gas inlet 4)

First career $O_2$=10sccm (introduced into the gas inlet 4)

Second career Ar=20sccm (introduced into the gas inlet 200)

Second career $O_2$=10sccm (introduced into the gas inlet 200)

Reactant oxygen $O_2$=200sccm (introduced into the lower part 25 of the dispersion jet part)

Reactant oxygen temperature 216°C (temperature controlled by a separately installed heater before introducing from the lower part of the dispersion jet part)

| Wafer temperature | 475°C |
|---|---|
| Space temperature | 299°C |
| Space distance | 30mm |
| Temperature of shower head | 201°C |

| Reaction pressure | 1Torr |
|---|---|
| Deposition time | 1 min |

As a result,

| SBT film thickness about 5nm (depositing speed about 5nm/min) | | |
|---|---|---|
| SBT composition | Ba | 50.2 at% |
| | Sr | 25.1 at% |
| | Ti | 24.7 at% |

After the SBT thin film had been formed, it was put under the crystallization process at 650°C for 30 minutes under the oxygen atmosphere to form an upper electrode, then the dielectric constant showed 250 after the measurement and the evaluation.

(Embodiment 11)

This embodiment is an example of forming metal Ir thin film.
Metal Ir thin film was formed using the vaporizer shown in Fig. 19 and 20 and the CVD device shown in Fig. 21. Concretely, conditions of the vaporizer and the reaction chamber conditions were controlled as follows, and the metal Ir thin film was formed on an oxidized silicon substrate.
Concrete conditions:

| Ir(EtCp) (cod) 0.1 mole solution(solvent: Hexane) | 0.5ml/min |
|---|---|

First career Ar=200sccm (introduced into the gas inlet 4)
First career $O_2$=10sccm (introduced into the gas inlet 4)
Second career Ar=20sccm (introduced into the gas inlet 200)
Second career $O_2$=10sccm (introduced into the gas inlet 200)
Reactant oxygen $O_2$=200sccm (introduced into the lower part 25 of the dispersion jet part)
Reactant oxygen temperature 216°C (temperature controlled by a separately installed heater before introducing from the lower part of the dispersion jet part)

| Wafer temperature | 400°C |
|---|---|
| Space temperature | 290°C |
| Space distance | 30mm |
| Temperature of vaporizer | 150°C |
| Temperature of shower head | 180°C |
| Reaction pressure | 2Torr |
| Deposition time | 5 min |

As a result,

Ir film thickness, about 150 nm (depositing speed, about 30 nm/min)
The deposition thickness of Ru metallic-thin film is linearly proportional to the reaction time, by adding oxygen to the first career Ar=200sccm+ $O_2$=10sccm (introduced into the gas inlet 4). As for the vaporization tube in the vaporizer, the effect of partially progressing the oxidation reaction of Ir(EtCp) (cod) was confirmed, similar to the deposition of the SBT thin film.

(Embodiment 12)

This embodiment is an example of metal Ru thin film deposition.
Metal Ru thin film was formed using the vaporizer shown in Fig. 19 and 20 and the CVD device shown in Fig. 21, and electric characteristics or others were evaluated. Concretely, conditions of the vaporizer and the reaction chamber conditions were controlled as follows, and the metal Ru thin film was formed on an oxidized silicon substrate.
Concrete conditions:

Ru(EtCp)$_2$ 0.1 mole solution(solvent: Hexane) 0.5ml/min
First career Ar=200sccm (introduced into the gas inlet 4)
First career $O_2$=10sccm (introduced into the gas inlet 4)
Second career Ar=20sccm (introduced into the gas inlet 200)
Second career $O_2$=10sccm (introduced into the gas inlet 200)
Reactant oxygen $O_2$=200sccm (introduced into the lower part 25 of the dispersion jet part)
Reactant oxygen temperature 216°C (temperature controlled by a separately installed heater before introducing from the lower part of the dispersion jet part)

| Wafer temperature | 400°C |
|---|---|
| Space temperature | 290°C |
| Space distance | 30mm |
| Temperature of vaporizer | 150°C |
| Temperature of shower head | 180°C |
| Reaction pressure | 2Torr |
| Deposition time | 5 min |

As a result,

Ru film thickness, about 150 nm (depositing speed, about 30 nm/min)
The deposition thickness of Ru metallic thin film is linearly proportional to the reaction time, by adding oxygen to the first career Ar=200sccm+ $O_2$=10sccm (introduced into the gas inlet 4). As for the vaporization tube in the vaporizer, the effect of partially progressing the oxidation reaction of Ru(EtCp)$_2$ was confirmed, similar to the deposition of the SBT thin film.

(Embodiment 13)

This embodiment is a deposition example of a ferroelectric thin film PZT.
The PZT film was formed by using the vaporizer shown in Fig. 19 and 20 and the CVD device shown in Fig. 21, and the polarization characteristics or others were evaluated. Concretely, the conditions of the vaporizer and reaction chamber were controlled as follows, and the PZT thin film was formed on a substrate forming platinum 200nm on an oxidized silicon substrate.
Concrete depositing conditions of the PZT thin film:

| Pb(dpm)$_2$ 0.2 mole solution | 0.02 cc/min(solvent: Hexane) |
|---|---|
| Zr(dpm)$_4$ 0.1 mole solution | 0.02 cc/min(solvent: Hexane) |
| Ti(OiPr)$_2$(dpm)$_2$ 0.1 mole solution | 0.02 cc/min (solvent: Hexane) |

First career Ar=200sccm (introduce into the gas inlet 4)
First career $O_2$=10sccm (introduce into the gas inlet 4)
Second career Ar=20sccm (introduce into the gas inlet 200)
Second career $O_2$=10sccm (introduce into the gas inlet 200)
Reaction oxygen $O_2$=200sccm (introduce into the lower part 25 of the dispersion jet)

Reaction oxygen temperature 216°C (control the temperature by a separately installed heater before introducing into the lower part of the dispersion jet)

| | |
|---|---|
| Wafer temperature | 430°C |
| Space temperature | 299°C |
| Space distance | 30mm |
| Temperature of shower head | 201°C |
| Reaction pressure | 1Torr |
| Deposition time | 10 min |

As a result,

PZT film thickness is about 150 nm (depositing speed is about 150 nm/min)

| | |
|---|---|
| PZT composition | Pb 50.5 at% |
| | Zr 19.4 at% |
| | Ti 30.1 at% |

After this PZT thin film had been formed, it was crystallized at 550°C for 30 minutes in the oxygen atmosphere, an upper part electrode was formed and evaluated. As a result, the excellent crystallization characteristics and the polarization characteristics were shown. This is shown in Fig. 17 and 18.

(Embodiment 14)

This embodiment is a disposition example of the Cu thin film as an example of metallic thin film.
The Cu thin film was formed by using the vaporizer shown in Fig. 19 and 20 and the CVD device shown in Fig. 21. Concretely, the conditions of the vaporizer and reaction chamber were controlled as follows, and the CuO thin film was formed on a substrate forming platinum 200nm on an oxidized silicon substrate.
Concrete depositing conditions of the PZT thin film:

| | |
|---|---|
| CU(DIBM)$_2$ 0.2 mole solution | 0.02 CC/MIN(solvent: Hexane) |

First career Ar=200sccm (introduce into the gas inlet 4)
First career O$_2$=10sccm (introduce into the gas inlet 4)
Second career Ar=20sccm (introduce into the gas inlet 200)
Second career O$_2$=10sccm (introduce into the gas inlet 200)
Reaction oxygen O$_2$=200sccm (introduce into the lower part 25 of the dispersion jet)
Reaction oxygen temperature 216°C (control the temperature by a separately installed heater before introducing into the lower part of the dispersion jet)

| | |
|---|---|
| Wafer temperature | 430°C |
| Space temperature | 299°C |
| Space distance | 30mm |
| Temperature of shower head | 201°C |
| Reaction pressure | 1Torr |
| Deposition time | 2 min |

As a result,

PZT film thickness is about 400 nm (depositing speed is about 200 nm/min) After this CuO thin film had been formed, it was crystallized at 550°C for 30 minutes in the hydrogen atmosphere, it was reduced to metal copper.

Industrial Applicability

Following, various effects were able to be achieved according to the present invention.

1. A ferroelectric thin film that has the best composition to obtain an excellent remanent polarization characteristic and has the bismuth type layered crystal structure with high reliability can be formed with satisfactory controllability and reproducibility.
2. A thin film crystal of low content of impurity carbon (0.2wt% or less) can be formed with satisfactory controllability and reproducibility, taking a ferroelectric $Sr_xBi_yTa_2O_{9\pm d}$ ($2.60 \leqq x < 1.00, 2.00 < y \leqq 2.50$) of bismuth type layer structure as main phase.
3. The impurity carbon is decreased and the perovskite crystallization is made to be progressed through a heat treatment of tens of minutes at 400 to 580°C in temperature, in an oxidizing atmosphere, after the depositing of the aforementioned thin film.
4. When a suitable electrode is formed on the aforementioned thin film, an excellent strong dielectric characteristic is obtained.
5. As the SBT.CVD thin film of the prior art had to be heat treated at 800°C for about 60 minutes, after it had deposited, a characteristic not oxidized even if heat-treated as mentioned above has been requested, especially for the lower electrode; consequently, platinum has been largely adopted. This is, expensive, and the fine processing is extremely difficult.

According to the present invention, heatproof and oxidation resistance standard of the lower electrode material become less strict, because it is able to make the heat-treatment temperature after the depositing remarkably low, and materials that can make the fine processing easier (example; RuOx,TiN,TiON etc) can be adopted.
Table 3 CVD material for high/ferroelectric, metal/barrier metal formation Element Compound Formula Formula weight Fusion point [ °C ] Temperature [°C]/0.01Torr Solution flush Holding Liquid

**Claims**

**1.** A ferroelectric thin film of layered crystal structure comprising at least tantalum and oxygen (O) among carbon, Strontium (Sr), bismuth (Bi), tantalum (Ta), and niobium (Nb), of which a composition formula is $SrBi_yTa_2O_{9\pm d}$ or $Sr_xBi_y(Ta,Nb)_2O_{9\pm d}$ (provided that, $0.90 \leqq x < 1.00$, $1.70 < y \leqq 3.20$, and $0 \leqq d \leqq 1.00$) and the carbon content is 5at% or less.

**2.** The ferroelectric thin film of claim 1, wherein y is $1.80 \leqq y \leqq 3.00$, and the carbon content is 5at% or less of.

**3.** The ferroelectric thin film of claim 1 or 2, **characterized in that** it is made by flash CVD method.

**4.** A manufacturing method of ferroelectric thin film, comprising steps of:

dispersion for atomization of a solution that disperses or dissolves in a solvent an organometallic complex including respective elements of at least strontium (Sr), bismuth (Bi), and tantalum (Ta);
vaporization to vaporize it in a vaporization chamber;
gas mixture for mixing a career gas including a vaporized organometallic complex, and oxidizing gases such as an oxygen gas, an ozone gas, at a prescribed rate;
thin film formation for forming an oxide thin film by making the career gas including the mixed organometallic complex react with the oxidizing gas in a reaction chamber within a prescribed range of pressure for decomposition, and depositing it on a substrate heated within a prescribed range of temperature; and
heat treatment for forming a ferroelectric thin film of a desired bismuth layer structure by applying a heat-treatment of a prescribed range of temperature to the oxide thin film formed on the substrate and giving a crystallization process performing a composition control.

**5.** The manufacturing method of ferroelectric thin film of claim 4, wherein said crystallization heat-treatment process is performed in an oxidizing atmosphere at 400 to 580°C in temperature.

**6.** The manufacturing method of ferroelectric thin film of claim 4, wherein the temperature of the vaporization room is set to a range of temperature 180 to 240°C in said vaporization process.

**7.** The manufacturing method of ferroelectric thin film of claim 4, wherein at least one kind of argon (Ar), dry nitrogen ($N_2$), and helium is used as said career gas.

**8.** The manufacturing method of ferroelectric thin film of claim 7, **characterized by** setting the mixture ratio (oxygen/career gas) of oxygen gas to career gas including the vaporized organometallic complex to a range of 50 to 150%.

**9.** The manufacturing method of ferroelectric thin film of claim 4, **characterized by** setting the temperature of said substrate to a range of 300 to 580°C in said thin film formation process.

**10.** The manufacturing method of ferroelectric thin film of claim 4, **characterized by** setting the pressure in the reaction chamber to a range of 0.2 to 12Torr in said thin film formation process.

**11.** The manufacturing method of ferroelectric thin film of claim 10, **characterized by** setting the pressure in the reaction chamber to a range of 0.3 to 3Torr in said thin film formation process.

**12.** The manufacturing method of ferroelectric thin film of claim 4, wherein the ferroelectric thin film is formed by performing heat-treatment of oxide thin film at a temperature within the range of 400 to 580°C in said heat-treatment process.

**13.** A ferroelectric device **characterized by** having the ferroelectric thin film of claim 1 or 2.

**14.** A thin film formed by using a deposition device comprising a vaporizer provided with a radiation prevention part having a small hole outside the gas outlet having:

① a dispersion part including:

a gas passage formed internally,
a gas inlet to introduce a career gas into the gas passage,
a means to supply a raw material solution to the gas passage,
a gas outlet to send the career gas including the raw material solution to a vaporization part, and
a means to cool the gas passage, and

② a vaporization part for heating and vaporizing the career gas including the atomized raw material solution, sent from said dispersion part, the vaporization part comprising:

a vaporization tube whose one end is connected to a reaction part of various units such as deposition, and the other end is connected to said gas outlet, and
a heating means to heat the vaporization tube.

**15.** The thin film of claim 14, **characterized in that** it is a dielectric thin film, a metallic thin film or an oxide electroconductive thin film.

**16.** The thin film of claim 14 or 15, **characterized by** installing a cooling means to cool a portion where said dispersion part and said vaporization part are connected to each other.

**17.** The thin film of any one of claims 14 to 16, **characterized in that** said radiation prevention part is tapered to increase in the inside diameter from the dispersion part side toward the vaporization part side.

**18.** The thin film of any one of claims 14 to 17, **characterized in that**:

said dispersion part comprises a dispersion main body having a cylindrical or conical hollow part and a rod having an outer diameter smaller than the inner diameter of the cylindrical or conical hollow part, and
the rod is inserted in the cylindrical or conical hollow part.

**19.** The thin film of any one of claims 14 to 18, **characterized in that** the angle of the cone of said conical hollow part is 0 to 45 degrees.

**20.** The thin film of any one of claims 14 to 19, **characterized in that** the angle of the cone of said conical hollow part is 8 to 20 degrees.

**21.** The thin film of any one of claims 14 to 20, **characterized in that**:

> said dispersion part comprises a dispersion main body having a cylindrical or conical hollow part and a rod having an outer diameter substantially equal to the inner diameter of the cylindrical or conical hollow part, the rod has one or more groove(s) on the outer periphery thereof, and,
> said rod is inserted in the cylindrical or conical hollow part.

**22.** The thin film of claim 21, **characterized in that** said groove is a straight line groove.

**23.** The thin film of claim 21 **characterized in that** said groove is a spiral groove.

**24.** The thin film of any one of claims 14 to 23, **characterized in that** said raw material solution is a uniform solution or a liquid including fine particles of the size of 1 to 100nm.

**25.** The thin film of any one of claims 14 to 24, **characterized by** installing a heating means on the bottom of a container of said raw material solution.

**26.** A thin film formed by using a deposition device comprising a vaporizer having:

> ① a dispersion part including:
>
> > a gas passage formed internally,
> > a gas inlet to introduce a pressurized career gas into the gas passage,
> > a means to supply the raw material solution to the gas passage, and
> > a gas outlet to send the career gas including the raw material solution to the vaporization part, and
>
> ② a vaporization part for heating and vaporizing the career gas including the raw material solution, sent from said dispersion part, the vaporization part comprising:
>
> > a vaporization tube whose one end is connected to a reaction part of various units such as a deposition, and the other end is connected to said gas outlet, and
> > a heating means to heat the vaporization tube; wherein
>
> ③ said dispersion part comprises
> > a dispersion main body having a cylindrical or conical hollow part and
> > a rod having an outer diameter smaller than the inner diameter of the cylindrical or conical hollow part, in which
> the rod has one or more spiral groove(s) on the vaporizer side of the outer periphery thereof, and is inserted in the hollow part, and its inner diameter expands in a taper shape toward the vaporizer side, and
> ④ a radiation prevention part having a small hole on the gas outlet side and the inner diameter expanding towards the vaporizer side is installed outside the gas outlet.

**27.** The thin film of claim 14, **characterized in that** it is a dielectric substance thin film, a metallic thin film or an oxide electroconductive thin film.

**28.** The thin film of claim 26 or 27, **characterized in that** said small hole has such a size that a velocity of the jetting gas flow is subsonic.

**29.** The thin film of any one of claims 26 to 28, **characterized in that** the cross sectional area of said small hole is smaller than the cross sectional area of said gas passage.

**30.** The thin film of any one of claims 26 to 29, **characterized in that** the cross sectional area of said small hole is 1/2 or less of the cross sectional area of said gas passage.

**31.** The thin film of any one of claims 26 to 30, **characterized in that** the cross sectional area of said small hole is 1/3 or less of the cross sectional areas of said gas passage

**32.** The thin film of any one of claims 26 to 31, **characterized in that** the material consisting said small hole is made of a material with good thermal conductivity.

**33.** The thin film of any one of claims 26 to 32, **characterized in that** the length of said small hole is five times or more of said small hole size.

**34.** The thin film of any one of claims 26 to 33, **characterized in that** the length of said small hole is ten times or more of said small hole size.

**35.** The thin film of any one of claims 26 to 34, **characterized by** installing a means to cool said gas passage.

**36.** The thin film of any one of claims 26 to 35, **characterized by** installing a cooling means to cool a connection part for connecting said dispersion part and said vaporization part.

**37.** The thin film of any one of claims 26 to 36, **characterized in that** the surface of said rod is a surface where electrolytic polishing or compound electrolysis grinding is exerted.

**38.** The thin film of any one of claims 26 to 37, **characterized by** installing a means to cool the gas passage.

**39.** The thin film of any one of claims 26 to 38, **characterized by** installing a cooling means to cool a portion for connecting said dispersion part and said vaporization part.

**40.** The thin film of any one of claims 26 to 39, **characterized in that** said raw material solution is a liquid including the complete solvent liquid or fine particles of the size of 1 to 100nm.

**41.** The thin film of any one of claims 26 to 40, **characterized by** installing a heating means on the bottom in the container of said raw material solution.

**42.** A thin film formed by using a deposition device having a vaporizer comprising;

    ① a dispersion part including:

        a gas passage formed internally,
        a gas inlet to introduce a career gas into the gas passage,
        a means to supply a raw material solution to the gas passage,
        a gas outlet to send the career gas including the raw material solution to a vaporization part, and
        a means to cool the gas passage, and

    ② a vaporization part for heating and vaporizing the career gas including the raw material solution, sent from said dispersion part, the vaporization part including;

        a vaporization tube whose one end is connected to a reaction part of various units such as a deposition, and the other end is connected to said gas outlet, and
        a heating means to heat the vaporization tube, wherein

    an oxidizing gas can be added to the carrier gas from the gas inlet or the oxidizing gas can be introduced from a primary oxygen supply port.

**42.** The thin film of claim 41, **characterized in that** it is a dielectric substance thin film, a metallic thin film or an oxide electroconductive thin film.

**43.** The thin film of claim 41 or 42, **characterized by** being able to introduce a second career gas and/or an oxidizing gas into the immediate proximity of said dispersion part.

**44.** The thin film of any one of claims 41 to 43, **characterized by** installing a cooling means to cool a portion for connecting said dispersion part and said vaporization part.

**45.** The thin film of any one of claims 41 to 44, **characterized in that** the portion connecting said dispersion part and said vaporization part forms a taper portion whose inside diameter increases from the dispersion part side toward the vaporization part side.

**46.** The thin film of any one of claims 41 to 45, **characterized in that**;
said dispersion part comprises a dispersion main body having a cylindrical or conical hollow part and a rod having an outer diameter smaller than the inner diameter of the cylindrical or conical hollow part, and
the rod is inserted into the cylindrical or conical hollow part.

**47.** The thin film of any one of claims 41 to 46, **characterized in that**:

said dispersion part comprises a dispersion main body having a cylindrical or conical hollow part and a rod having an outer diameter smaller than the inner diameter of the cylindrical or conical hollow part,
the rod has one or more spiral groove(s) on the outer periphery thereof, and,
the rod is inserted in the cylindrical or conical hollow part.

**48.** The thin film of claim 47, **characterized in that** said groove is a straight groove.

**49.** The thin film of claim 47, **characterized in that** said groove is a spiral groove.

**50.** The thin film of any one of claims 41 to 49, **characterized in that** the flow velocity of the gas or others flowing in said groove is 10m/sec or more.

**51.** The thin film of any one of claims 41 to 50, **characterized in that** the flow velocity of the gas or others flowing in said groove is 15m/sec or more.

**52.** The thin film of any one of claims 41 to 51, **characterized in that** said raw material solution is a complete solvent liquid or a liquid including fine particle of the size of 1 to 100nm.

**53.** The thin film of any one of claims 41 to 52, **characterized by** installing a heating means on the bottom in the container of said raw material solution.

**54.** The thin film of any one of claims 41 to 53, **characterized in that** said oxidizing gas is either one kind or more of $O_2$, $N_2O$ and $NO_2$.

**55.** A thin film formed by using a deposition device having a vaporizer comprising;

① a dispersion part including:

a gas passage formed internally,
a gas inlet to introduce a career gas into the gas passage,
a means to supply the raw material solution to the gas passage,
a gas outlet to send the career gas including the raw material solution to the vaporization part, and
a means to cool the gas passage, and

② a vaporization part for heating and vaporizing the career gas including the raw material solution, sent from said dispersion part, the vaporization part including;
a vaporization tube whose one end is connected to a reaction part of various units such as a deposition, and the other end is connected to said gas outlet, and
a heating means to heat the vaporization tube, wherein

a radiation prevention part having a small hole is installed outside said gas outlet, and
the career gas and an oxidizing gas can be introduced from said gas inlet.

**56.** The thin film of claim 55, **characterized in that** said thin film is a dielectric substance thin film, a metallic thin film or an oxide electroconductive thin film.

**57.** The thin film of claim 55 or 56, **characterized by** being able to introduce a second career gas and/or an oxidizing gas into the immediate proximity of said dispersion part.

**58.** The thin film of any one of claims 55 to 57, **characterized by** installing a cooling means to cool a portion for connecting said dispersion part and said vaporization part.

**59.** The thin film of any one of claims 55 to 58, **characterized in that** the portion for connecting said dispersion part and said vaporization part forms a taper portion whose inside diameter increases from the dispersion part side toward the vaporization part side.

**60.** The thin film of any one of claims 55 to 59, **characterized in that**:

said dispersion part comprises a dispersion main body having a cylindrical or conical hollow part and a rod having an outer diameter smaller than the inner diameter of the cylindrical or conical hollow part, and the rod is inserted into the cylindrical or conical hollow part.

**61.** The thin film of any one of claims 55 to 60, **characterized in that** said raw material solution is a complete solvent liquid or a liquid including fine particle of the size of 1 to 100nm.

**62.** The thin film of any one of claims 55 to 61, **characterized by** installing a heating means on the bottom in the container of said raw material solution.

**63.** The thin film of any one of claims 55 to 62, **characterized in that**;

said dispersion part comprises a dispersion main body having a cylindrical or conical hollow part and a rod having an outer diameter substantially equal to the inner diameter of the cylindrical or conical hollow part, the rod has one or more spiral groove(s) on the outer periphery thereof, and, the rod is inserted in the cylindrical or conical hollow part.

**64.** The thin film of claim 55, characterize in that said groove is a straight groove provided in the cylindrical or conical hollow part.

**65.** A thin film formed by using a deposition device having a disperser comprising;

a plurality of passages for supplying raw material solution,
a mixture part for mixing a plurality of raw material solutions supplied from a plurality of solution passages,
a supply passage of which one end communicates with the mixture part and has an outlet of the vaporization part side,
a gas passage arranged to spray the career gas or the mixed gas of the career gas and oxygen to the mixture raw material solution carried from the mixture part in the supply passage, and
a cooling means to cool the supply passage.

**66.** The thin film of claim 65, **characterized in that** said thin film is a dielectric substance thin film, a metallic thin film or an oxide electroconductive thin film.

**67.** A thin film formed by using a deposition device comprising:

a disperser, having;
a plurality of solution passages for supplying raw material solution,
a mixture part for mixing a plurality of raw material solutions supplied from a plurality of solution passages,
a supply passage of which one end communicates with the mixture part and has an outlet of the vaporization part side,
a gas passage arranged to spray the career gas or the mixed gas of the career gas and oxygen to the mixture raw material solution from the mixture part, in the supply passage, and
a cooling means to cool the supply passage; and
a vaporizer, having;
a radiation prevention part having a small hole outside the gas outlet, and
a primary oxygen supply port enabling to introduce an oxidizing gas in the direct proximity of the dispersion jet part; and
the vaporizer having;
a vaporization part for heating and vaporizing the career gas including the raw material solution, sent from said dispersion part,
a vaporization tube whose one end is connected to a reaction part of various units such as a deposition, and the other end is connected to said outlet of the disperser, and
a heating means to heat the vaporization tube.

**68.** The thin film of claim 67, **characterized in that** said thin film is a dielectric substance thin film, a metallic thin film or an oxide electroconductive thin film.

**69.** The thin film of claim 68, **characterized by** installing, a first oxygen supply port for introducing heated oxidizing gas of which the temperature is controlled with a high accuracy under said vaporization part.

**70.** The thin film of claim 68 or 69, **characterized by** making it possible to control the temperature of the heated oxidizing gas of which the temperature is controlled with a high accuracy, to the temperature of the heating tube (vaporization tube) ±30°C.

**71.** The thin film of any one of claims 68 to 70, **characterized by** making it possible to control the temperature of the oxidizing gas whose temperature is controlled with a high accuracy by heating, to the temperature of the heating tube (vaporization tube) ±10°C.

**72.** The thin film of any one of claims 68 to 71, **characterized by** installing a means to heat so that the tube wall temperature may become uniform.

**73.** The thin film of any one of claims 68 to 72, **characterized in that** a heater is set or controlled so that the heating calorie of a vaporization tube upper part are may become higher than the heating calorie of the downstream area.

**74.** The thin film of any one of claims 68 to 73, **characterized by** having a length necessary for raising gas temperature of the interior of the vaporization tube to the vicinity of a preset temperature.

**75.** The thin film of any one of claims 68 to 74, **characterized by** making the angle between the career flow passage and the raw material solution inlet from 30 to 90 degrees.

**76.** The thin film of any one of claims 68 to 75, **characterized in that** said deposition device is a CVD device.

**77.** The thin film of any one of claims 68 to 75, **characterized in that** said deposition device is a MOCVD device.

**78.** The thin film of any one of claims 68 to 77, **characterized by** having a heated shower head that uniformly disperses the heated and gasified reaction gas over a large area.

**79.** The thin film of claim 78, **characterized by** installing a means for uniformly heating said shower head to a given temperature by using heated high temperature gas (air, argon, etc.) .

**80.** The thin film of any one of claims 16 to 79, **characterized in that** said thin film is an SBT thin film.

**81.** The thin film of any one of claims 78 to 80, **characterized by** installing a mechanism that controls in precision the temperature of the space between the shower head and a susceptor.

**82.** The thin film of any one of claims 78 to 80, **characterized by** installing a mechanism to control the distance of the space between the shower head and the susceptor to an arbitrary distance.

**83.** The thin film of any one of claims 16 to 82, **characterized by** installing a liquid mass flow controller to control the quantity of flowing of raw material solution and, at the same time, installing a deaerator means to vent on the upstream side of the liquid mass flow controller.

**84.** The thin film of claim 83, **characterized by** installing a means to control the temperature of the raw material solution, a helium press-feed container, the liquid mass flow controller, and pipings before and behind to a given temperature.

**85.** A thin film deposited by using a deposition method including a vaporization method; the vaporization method comprising steps of, introducing raw material solution into a gas passage, shearing/atomizing the raw material solution by jetting the career gas to the introduced raw material solution to obtain raw material mist and, then, supplying the raw material mist to a vaporization part for making it vaporize, wherein;

the career gas is made to include oxygen.

**86.** The thin film of claim 85, **characterized in that** the jet speed of said career gas is 10 to 200m/s.

**87.** The thin film of claim 85 or 86, **characterized by** introducing the raw material solution by 0.005 to 2cc/min.

**88.** The thin film of any one of claims 85 to 87, **characterized by** flowing the career gas or the raw material gas, making a spiral flow and a straightly advancing flow that flows in the spiral flow upper layer concomitant in the downstream from the portion where the raw material solution was introduced.

**89.** The thin film of any one of claims 85 to 88, **characterized by** cooling the raw material gas between the portion introducing the raw material solution and said vaporization part.

**90.** The thin film of any one of claims 85 to 89, **characterized by** uniformly heating the wall of the vaporization tube by using heat medium that consists of liquid or gas with large thermal capacity.

**91.** The thin film of any one of claims 85 to 90, **characterized by** feeding the raw material solution forcefully by using helium having low gas solubility.

**92.** The thin film of any one of claims 85 to 91, **characterized by** controlling the quantity of flowing of raw material solution with precision by using the liquid mass flow controller and so on, after degasifying the gas that has dissolved slightly.

**93.** The thin film of claims 85 to 92, **characterized by** controlling the temperature of the raw material solution, a helium forced feed container, and the liquid mass flow controller, and pipings before and behind to a given temperature.

**94.** The thin film of claim 93, **characterized by** controlling it within the range of 5 to 20°C, when the SBT thin film is to be formed.

**95.** The thin film of claim 93 or 94, **characterized by** controlling it within the range of 12±1°C when the SBT thin film is to be formed.

**96.** The thin film of any one of claims 85 to 95, **characterized by** controlling the temperature of the raw material solution, a helium forced feed container, and the liquid mass flow controller, and pipings before and behind to a given temperature.

**97.** The thin film of any one of claims 85 to 96, **characterized by** restraining the quantity of flowing change when a reactant gas is flowed into a reaction chamber, by continuing to flow the depositing gas to the vent side trough the vaporizer, during the reaction waiting time.

**98.** The thin film of any one of claims 85 to 97, **characterized by** restraining the pressure change and the quantity of flowing change when the reactant gas is flowed into the reaction chamber, by controlling the pressure of the vaporizer, when the reactant gas is flowed continuously to the vent side trough the vaporizer, during the reaction waiting time.

**99.** The thin film of any one of claims 85 to 98, **characterized by** uniformly dispersing the heated and gasified reaction gas over a large area by using a heated shower head.

**100.** The thin film of any one of claims 85 to 99, **characterized by** uniformly heating said shower head to a given temperature by using heated high temperature gas (air, argon, etc.).

**101.** The thin film of any one of claims 85 to 100, **characterized by** controlling the temperature of the shower head to 180 to 250°C.

**102.** The thin film of any one of claims 85 to 101, **characterized by** controlling the temperature of the shower head to 200 to 220°C.

**103.** The thin film of any one of claims 85 to 102, **characterized in that** said thin film is a dielectric substance thin film, a metallic thin film or an oxide electroconductive thin film.

**104.** The thin film of any one of claims 85 to 103, **characterized in that** said thin film is an SBT thin film.

**105.** An electric/electronic device **characterized by** having the thin film of any one of claims 1 to 104.

Fig. 1

# Fig. 2

29 Raw material supply port

Cooling water

Cooling water

3

25 Oxygen supply port

21 Heater

102

20 Vaporization tube

22 Vaporization part   8 Dispersion part

Deposition device

Fig. 3

Collecting part | Reaction part | Supply part

46
Gas pack

Vaporizer

Mass flow controller

41

Exhaust

40

42
exhaust port

43
Electric furnace

44
Reaction tube

Valve

Oxygen

34d    30d    31d    32d

34c    30c    31c    32c

Ta (OC$_2$H$_5$)$_5$／THF
Sr (DPM)$_2$／THF
Bi (C$_6$H$_5$)$_3$／THF
THF

33  Career gas canister

34b · 30b    31b    32b

30a

31a

32a Reserve tank

##### Heating space

30a
Liquid mass flow controller

EP 1 363 320 A1

Fig. 4

Raw material
solution

Argon

31b

32b

Raw material solution

Fig. 5

## Fig. 6

Fig. 7

(a)

10

Groove(gas passage)

(b)

71

gas passage

10

Fig. 8

Fig. 9

Fig. 10

Fig. 11

# Fig. 12

EP 1 363 320 A1

Fig. 13

40

Fig. 14

Fig. 15

Fig. 16

Metal filter

$10 \mu m$

(a)

(b)

Fig. 17

Fig. 18

# Fig. 19

Fig. 20

Sheathed heater

Palma

Vaporization head

Controller

Heat exchnger

Vaporization part
Proper distance and
temperature

Pressure
gauge

Automatic control
valve of
vaporization part

Mantle heater

thermo couple

$O_2$ or Ar
(switching)

Introduced gas
(rotating mixture)

Horizontal sectional view
(Gas flow image)

Shower head

Hot wall chamber

thermo couple

EP 1 363 320 A1

Fig. 21

# Fig. 22

Upper electrode:Ir/IrOx

Ferroelectric

Lower electrode: Ir/IrOx

barrier

## Fig. 23

**DRAM**

Transistor    Ferroelectric capacitor

**FeRAM**

Transistor    Ferroelectric capacitor
= nonvolatile

Ferroelectric

Cross sectional view of memory cell unit

Dielectric

DRAM cell structure
(256M~1G)

FeRAM cell structure
(~1G)

Ferroelectric

## Fig. 24

Fig. 25

## INTERNATIONAL SEARCH REPORT

| | International application No. |
|---|---|
| | PCT/JP02/00302 |

A. CLASSIFICATION OF SUBJECT MATTER
   Int.Cl⁷ H01L21/316, H01L21/31

According to International Patent Classification (IPC) or to both national classification and IPC

B. FIELDS SEARCHED

Minimum documentation searched (classification system followed by classification symbols)
   Int.Cl⁷ H01L21/316, H01L21/31

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2002 |
| Kokai Jitsuyo Shinan Koho | 1971-2002 | Toroku Jitsuyo Shinan Koho | 1994-2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X .<br>Y | JP 2000-336481 A (Toshiba Corp.),<br>05 December, 2000 (05.12.00),<br>Claim 2; Par. Nos. [0004], [0014], [0039], [0055]<br>(Family: none) | 1-3<br>4-13 |
| X | EP 992611 A (Matsushita Electric Industrial Co.,<br>Ltd.),<br>12 April, 2000 (12.04.00),<br>Fig. 1<br>& JP 2000-183057 A<br>Par. Nos. [0009], [0060]; Fig. 1<br>& KR 2000028938 A        & US 6191054 B | 1-3 |
| Y<br>X<br>Y | JP 2000-216150 A (K.K. Watanabe Shoko),<br>04 August, 2000 (04.08.00),<br>Par. Nos. [0012], [0014], [0041], [0179]; Figs. 2,<br>5, 8<br>(Family: none) | 4-13<br>14-41<br>42-105 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 April, 2002 (10.04.02) | 23 April, 2002 (23.04.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

**INTERNATIONAL SEARCH REPORT**

International application No.

PCT/JP02/00302

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 10-287425 A (Nippon Telegraph And Telephone Corp.),<br>27 October, 1998 (27.10.98),<br>Claim 1<br>(Family: none) | 4-13 |
| Y | WO 99/02756 A (Symetrix Corp.),<br>21 January, 1999 (21.01.99),<br>Fig. 1<br>& US 5997642 A      & EP 998594 A<br>& CN 1263569 A      & JP 2001-509641 A<br>& KR 2001021904 A | 1-13 |
| Y | JP 7-054151 A(Matsushita Electric Industrial Co., Ltd.),<br>28 February, 1995 (28.02.95),<br>Page 3, right column , lines 21 to 29<br>(Family: none) | 42-105 |
| Y | JP 58-180017 A (Director General,Agency of Industrial Science and Technology),<br>21 October, 1983 (21.10.83),<br>Claim 3<br>(Family: none) | 42-105 |

Form PCT/ISA/210 (continuation of second sheet) (July 1998)

54